# EUROPEAN PATENT SPECIFICATION

(11) **EP 2 975 158 B1**
(45) Date of publication and mention of the grant of the patent: **24.10.2018**
(21) Application number: 14763228.5
(22) Date of filing: 07.03.2014
(51) Int. Cl.: H01J 37/32, C23C 16/509, H01L 21/31, H05H 1/46, C23C 16/54, C23C 16/50, H01J 37/34

(54) **PLASMA CVD DEVICE AND PLASMA CVD METHOD**
PLASMA-CVD-VORRICHTUNG UND PLASMA-CVD-VERFAHREN
DISPOSITIF CVD AU PLASMA ET PROCÉDÉ CVD AU PLASMA

(30) Priority: 15.03.2013 JP 2013052897; 26.03.2013 JP 2013063412
(43) Date of publication of application: 20.01.2016
(73) Proprietor: Toray Industries, Inc., Tokyo 103-8666 (JP)
(72) Inventor: SAKAMOTO, Keitaro, Mishima-shi Shizuoka 411-0824 (JP); TONAI, Shunpei, Otsu-shi Shiga 520-8558 (JP); EJIRI, Hiroe, Otsu-shi Shiga 520-8558 (JP); NOMURA, Fumiyasu, Otsu-shi Shiga 520-8558 (JP)
(74) Representative: Hoefer & Partner Patentanwälte mbB
(86) International application number: PCT/JP2014/055951
(87) International publication number: WO 2014/142023

(56) References cited:
- EP-A2- 0 448 098
- WO-A1-2008/014780
- JP-A- H03 247 769
- JP-A- 2003 303 699
- JP-A- 2003 303 699
- JP-A- 2004 235 105
- JP-A- 2004 323 928
- JP-A- 2005 347 278
- JP-A- 2005 347 278
- JP-A- 2006 252 843
- JP-A- 2006 252 843

## Description

### Technical Field of the Invention

Our invention is a plasma CVD device and a plasma CVD method to form a thin film on a surface of substrate.

### Background Art of the Invention

Various methods to form a functional thin film by a plasma CVD method on various substrate surface have been studied so far. The thin film obtained by the plasma CVD method has characteristics, such as compactness, flexibility, transparency and electrical characteristic, so as to be applied to materials for forming a layer, such as surface protective layer of a magnetic recording material, hard coat layer, gas barrier layer and power generation layer of a thin-film solar cell.

The plasma CVD method is a method comprising supplying gaseous material as a raw material, decomposing the gas by energizing with plasma and bonding activated species chemically on the substrate to form a thin film. To enhance productivity of the thin film, it is necessary to promote the gas decomposition with plasma, supply the activated species made from the decomposed gas as many as possible onto the substrate surface and deposit the species to develop the thin film. Therefore measures have been studied to enhance the plasma density. Such an enhancement of the plasma density is regarded as being advantageous even for improvements of thin film quality and adhesion to the substrate.

A magnetron electrode concerning magnetic field can be employed to enhance the plasma density. The magnetron electrode technique can provide high-density plasma by designing tunnel-shaped magnetic field lines like a race track on a electrode to confine electrons.

Patent document 1 discloses a plasma CVD method applying a magnetron electrode. It describes that further decomposition of gas can be promoted by connecting the electrode with the gas inlet to extend the high-density plasma region.

Patent document 2 discloses a magnetron electrode having a magnetron-structural magnet in a pair of electrodes being at a floating level electrically. Such a magnetron electrode can enhance the reactivity in the plasma and form a high-quality film at high speed. Further, even on a substrate having a large area, uniform and stable film formation can be performed.

Patent document 3 discloses an electrode having an ejection hole to eject plasma generated by hollow-cathode discharge, in which the electrode incorporates a magnet for forming a magnetron magnetic field on the electrode surface. It describes that oxygen can be supplied through the ejection hole while a silane compound can be supplied from another ejection part of raw materials in the electrode. Such devices and methods can provide a thin film having a high compactness and good adhesion and being capable of reducing heat load on the substrate.

### Prior art documents

### Patent documents

Patent document 1: JP2011-524468-A
Patent document 2: JP2006-283135-A
Patent document 3: JP2008-274385-A
Patent document 4: JP2003-03699-A
Patent document 5: JP2005-347278-A
Patent document 6: JP2006-252843-A

### Summary of the Invention

### Problems to be solved by the Invention

Although further improved productivity is demanded, Patent documents 1-3 could not enhance the film forming speed without degrading the film quality as follows.

In the method disclosed in Patent document 1, the film forming speed doesn't increase beyond a certain point even when electricity and gas are further introduced, so that the film forming is not performed stably because of abnormal discharge. This seems to be because the gas-supply point is too far from the high-density plasma region generated with magnetron plasma to sufficiently decompose the gas and increase the film forming speed. This seems to be also because the film adheres to the gas inlet as an electrode to make the gas supply and discharge unstable and cause the abnormal discharge.

The method disclosed in Patent document 2 couldn't improve the film forming speed sufficiently. This seems to be because the ejection port of the gas supply section at the electrode terminal is faced to the substrate and therefore the high-density plasma with magnetron plasma couldn't sufficiently act on ejected gas from the ejection port.

The method disclosed in Patent document 3 could sufficiently activate the gas supplied through the ejection hole. However, another gas is supplied to the substrate in parallel from the ejection port of raw materials. Therefore the raw materials are not deposited effectively on the substrate in a high use efficiency.

Patent documents 4,5, and 6 disclose a plasma CVD device comprising a plasma CVD electrode unit and a substrate-holding mechanism in a vacuum chamber, wherein the plasma CVD electrode unit comprises an anode, a cathode facing the anode at a distance, and a first gas supply nozzle supplying a gas through a plasma-generation space between the anode and the cathode, the substrate-holding mechanism being provided at a position to contact the gas passing through the plasma-generation space, characterized in that a gas-supply directional length of the anode and a gas-supply directional length of the cathode are longer than a distance between the anode and cathode.

To solve the above-described problems, the plasma device of the invention is as defined in claim 1, and the plasma CVD method as defined in claim 11.

### Effect according to the Invention

The plasma CVD device and the plasma CVD method using the plasma CVD device makes it possible that the gas is decomposed at a high decomposition efficiency so that the film is formed at a high deposition rate.

### Brief explanation of the drawings

[Fig. 1] Fig. 1 is a schematic section view of an example of plasma CVD device.
[Fig. 2] Fig. 2 is a perspective view of an electrode unit of the plasma CVD device shown in Fig. 1.
[Fig. 3] Fig. 3 is a schematic section view of another example of plasma CVD device.
[Fig. 4] Fig. 4 is a perspective view of an electrode unit of the plasma CVD device shown in Fig. 3.
[Fig. 5] Fig. 5 is a schematic section view of another example of plasma CVD device.
[Fig. 6] Fig. 6 is a schematic section view of another example of the plasma CVD device.
[Fig. 7] Fig. 7 is an enlarged view of an electrode unit of the plasma CVD device shown in Fig. 6.
[Fig. 8] Fig. 8 is an X-arrow view of the electrode unit shown in Fig. 7.
[Fig. 9] Fig. 9 is a schematic section view of another example of plasma CVD device.
[Fig. 10] Fig. 10 is an enlarged transparent view of a cylindrical electrode of the plasma CVD device shown in Fig. 9.
[Fig. 11] Fig. 11 is a schematic section view of another example of plasma CVD device.
[Fig. 12] Fig. 12 is a schematic section view of another example of plasma CVD device.
[Fig. 13] Fig. 13 is a schematic section view of another example of plasma CVD device.
[Fig. 14] Fig. 14 is a schematic section view of plasma CVD device according to Comparative Example 1.
[Fig. 15] Fig. 15 is a schematic section view of plasma CVD device according to Comparative Example 2.
[Fig. 16] Fig. 16 is a perspective section view of an example of bottom plate constituting an electrode unit of a plasma CVD device.

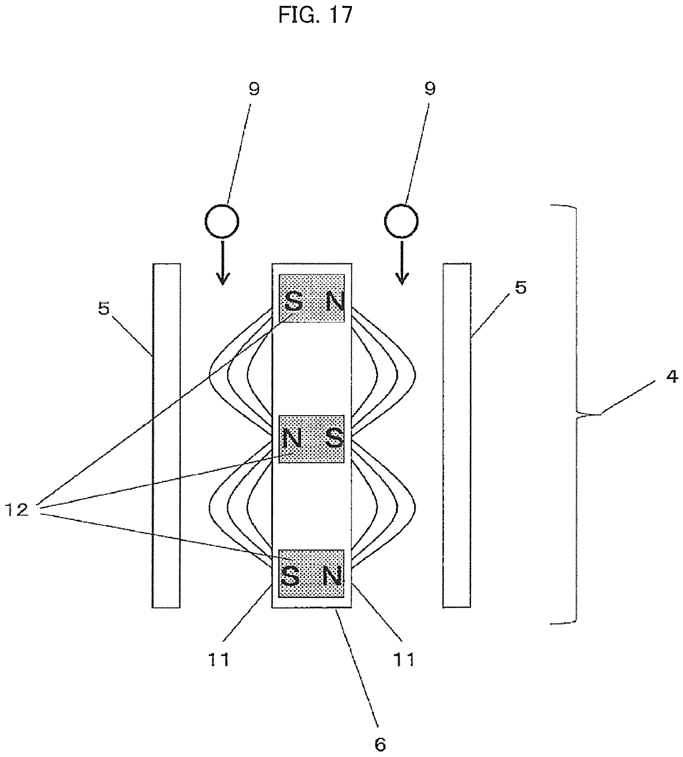

[Fig. 17] Fig. 17 is an enlarged view of another example of electrode unit of a plasma CVD device.
[Fig. 18] Fig. 18 is a schematic section view of another example of plasma CVD device.
[Fig. 19] Fig. 19 is a perspective view of an electrode unit of the plasma CVD shown in Fig. 18.

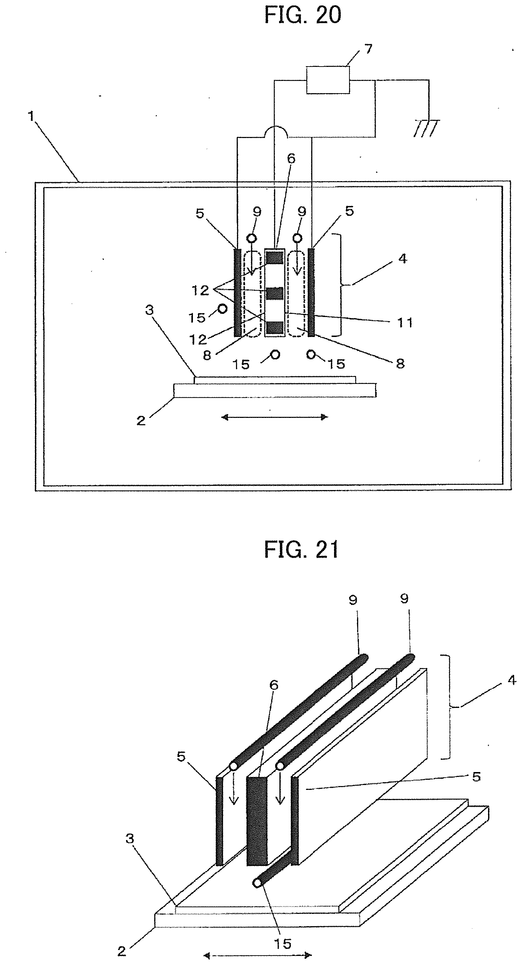

[Fig. 20] Fig. 20 is a schematic section view of another example of plasma CVD device.
[Fig. 21] Fig. 21 is a perspective view of an electrode unit of the plasma CVD device shown in Fig. 18.
[Fig. 22] Fig. 22 is a schematic section view of another example of plasma CVD device.
[Fig. 23] Fig. 23 is a schematic section view of another example of plasma CVD device.
[Fig. 24] Fig. 24 is a schematic section view of another example of plasma CVD device.
[Fig. 25] Fig. 25 is a schematic enlarged view of an example of gas supply nozzle.
[Fig. 26] Fig. 26 is a schematic enlarged view of another example of gas supply nozzle.
[Fig. 27] Fig. 27 is a schematic section view of another example of plasma CVD device.
[Fig. 28] Fig. 28 is a schematic section view of another example of plasma CVD device.
[Fig. 29] Fig. 29 is a schematic section view of another example of plasma CVD device.
[Fig. 30] Fig. 30 is a schematic section view of another example of plasma CVD device.
[Fig. 31] Fig. 31 is a schematic section view of another example of plasma CVD device.
[Fig. 32] Fig. 32 is a schematic section view of another example of plasma CVD device.
[Fig. 33] Fig. 33 shows a cathode height of a cylindrical cathode electrode.
[Fig. 34] Fig. 34 is a schematic section view of another example of plasma CVD device.
[Fig. 35] Fig. 35 is a schematic section view of another example of plasma CVD device.

### Embodiments for carrying out the Invention

Hereinafter, desirable embodiments of our invention will be explained with reference to the figures.

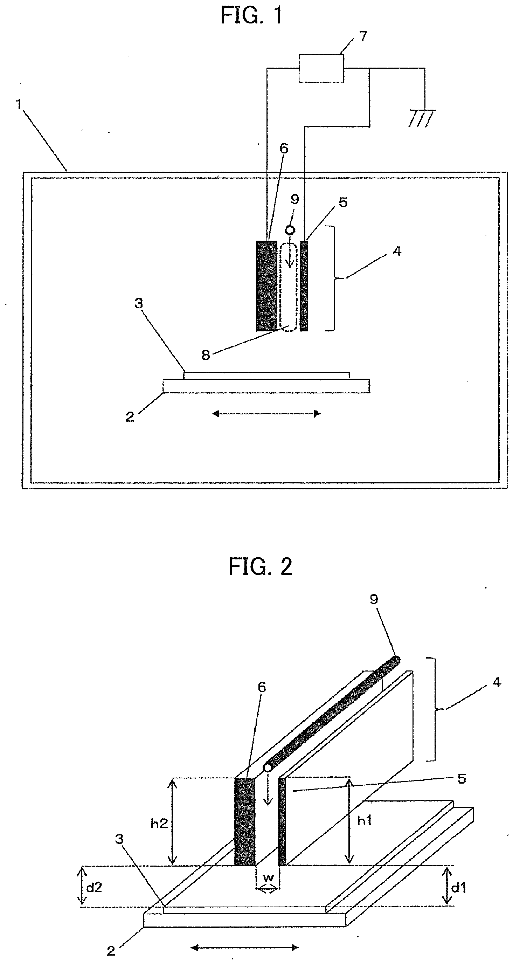

Fig. 1 is a schematic section view of an example of plasma CVD device. The plasma CVD device has substrate-holding mechanism 2 to hold substrate 3 and plasma CVD electrode unit 4 disposed as facing substrate-holding mechanism 2 inside vacuum chamber 1. Plasma CVD electrode unit 4 is provided with anode 5 and cathode 6 facing anode 5 at a distance. Power supply 7 is connected to cathode 6. Power supply 7 generates an electric field between anode 5 and cathode 6. By this electric field, plasma is produced in plasma-generation space 8 sectioned between anode 5 and cathode 6 inside plasma CVD electrode unit 4.

Plasma CVD electrode unit 4 has first gas supply nozzle 9. First gas supply nozzle 9 supplies gas to pass through plasma-generation space 8 between anode 5 and cathode 6. Substrate-holding mechanism 2 is disposed at a position where the gas flows in through plasma-generation space 8. With such a disposition of first gas supply nozzle 9, the gas can be supplied efficiently to plasma-generation space 8 to generate plasma, so that the gas decomposition efficiency is improved.

Because the decomposed gas flows toward substrate-holding mechanism 2 together with another gas flow ejected from first gas supply nozzle 9, the decomposed gas reaches substrate 3 surface efficiently to form a thin film. Therefore the film deposition rate improves.

Fig. 2 is a perspective view of plasma CVD electrode unit 4 of the plasma CVD device shown in Fig. 1. It is preferable that length h1 of anode 5 in the gas-supply direction and length h2 of cathode 6 in the gas-supply direction are longer than distance w between anode 5 and cathode 6. When lengths h1 and h2 are longer than distance w, the gas ejected from first gas supply nozzle 9 passes through a longer path in plasma-generation space 8, so that the gas decomposition efficiency is improved to rapidly form a thin film on substrate 3.

It is preferable that plasma CVD electrode unit 4 has a longer length parallel to the plane of substrate-holding mechanism 2 as shown in Fig. 2. When plasma CVD electrode unit 4 has such a shape, a film can be formed efficiently even when substrate 3 has a large area.

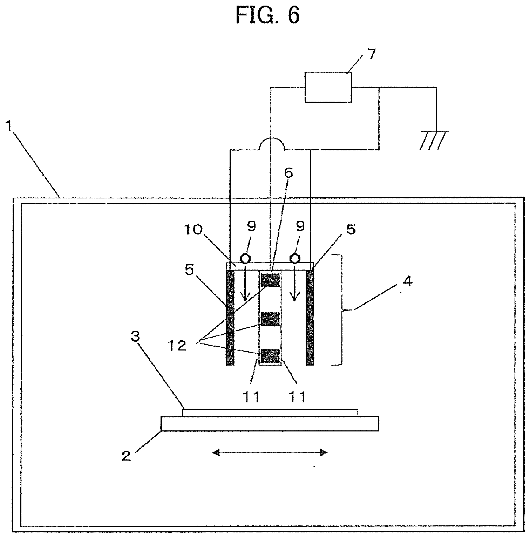

It is preferable that cathode 6 has magnet 12 inside and a plasma-generation surface on the side facing to anode 5, as shown in Fig. 6. With magnet 12, a magnetron magnetic field is formed on the surface of plasma-generation surface of cathode 6. Such a configuration can generate plasma on the surface of cathode 6, so that high-density plasma is generated in a compact space. Further, plasma CVD electrode unit 4 improves in flexibility of layout inside vacuum chamber 1.

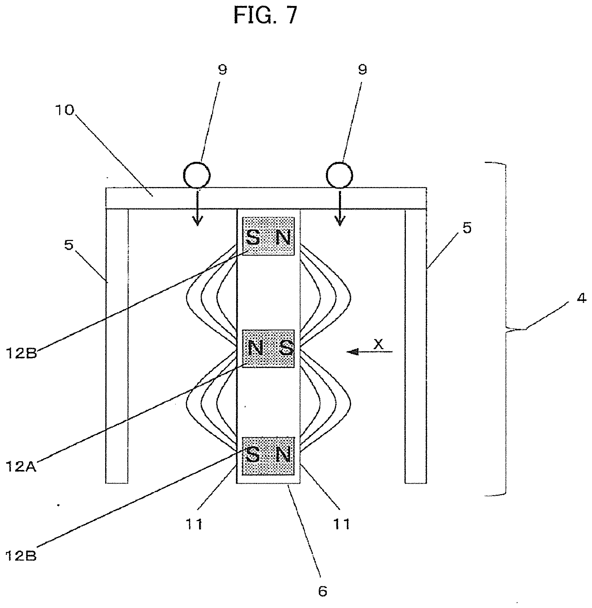

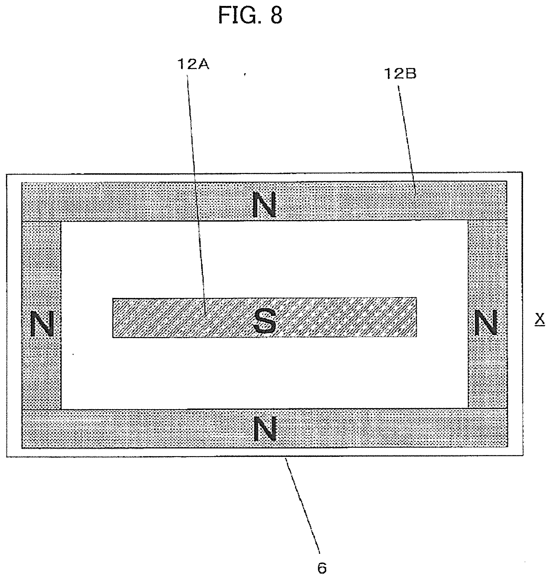

Fig. 7 is an enlarged view of cathode 6 of plasma CVD electrode unit 4 shown in Fig. 6. Fig. 8 is an X-arrow view of Fig. 7. As shown in Fig. 7 and Fig. 8, magnet 12A and magnet 12B are disposed inside cathode 6 so that magnet 12B surrounds magnet 12A. As shown in Fig. 8, center magnet 12A and peripheral magnet 12B have reversed surface polarities in terms of viewing cathode 6 along X-direction. Specifically, center magnet 12A has a surface of S pole of cathode 6 while peripheral magnet 12B has a surface of N pole of that, when viewed along X-direction. When cathode 6 is viewed from the opposite direction, center magnet 12A has a surface of N pole while peripheral magnet 12B has a surface of S pole. With magnets such disposed, a magnetron magnetic field is formed on the surface of cathode 6. With such a configuration, long magnetron plasma can be generated along the gas-supply direction on the surface of cathode 6, so that the gas ejected from gas supply nozzle 9 passes through a longer distance in high-density plasma-generation space 8. As a result, the gas decomposition efficiency improves to rapidly form a thin film on substrate 3. It is preferable that there is a cooling water flow path between magnets, although the flow path is not depicted. The cooling means may be water or another coolant. A cooled magnet can suppress the thermal demagnetization of magnet.

Length h1 of anode 5 in the gas-supply direction and length h2 of cathode 6 in the gas-supply direction can be set arbitrarily by considering the decomposition condition of gas supplied through first gas supply nozzle 9 and the mounting space of plasma CVD electrode unit 4. But when length h2 of cathode 6 in the gas-supply direction is less than 30mm, the length in the gas-supply direction might be shortened in the space where high-density plasma is generated with a magnetron magnetic field. When length h2 is more than 300mm, the space where high-density plasma is generated with the magnetron magnetic field might be present only close to the surface of cathode 6. Therefore it is preferable that length h2 of cathode 6 in the gas-supply direction is 30mm or more so that the high-density plasma is utilized efficiently and the gas ejected from first gas supply nozzle 9 is sufficiently decomposed while the gas passes through plasma-generation space 8. It is more preferably 50mm or more. It is preferable that length h2 of cathode 6 in the gas-supply direction is 300mm or less so that plasma CVD electrode unit 4 has an appropriate size to generate plasma uniformly in plasma-generation space 8. More preferably, it is less than 200mm.

It is preferable that length h1 of anode 5 in the gas-supply direction is equal to length h2 of cathode 6 in the gas-supply direction, although these lengths may be different. When plasma CVD electrode unit 4 comprises a pair of cathode 6 and anode 5 as shown in Fig. 2, h1 and h2 of the same length can prevent the gas from flowing outside plasma CVD electrode unit 4 so that the gas passes through plasma efficiently. Even when plasma CVD electrode unit 4 is provided with cathode 6 between anodes 5, cathode 6 and anode 5 of the same length h can achieve the same effect.

It is preferable that anode 5 is provided almost parallel to cathode 6, although these electrodes may not be parallel to each other. When anode 5 is almost parallel to cathode 6, plasma can be generated uniformly all over the region of plasma-generation space 8 and the gas decomposition efficiency can be enhanced. The term "almost parallel" means that anode 5 is designed to be parallel to cathode 6, and therefore "almost parallel" accepts a production error making a slight difference of the electrodes from precise parallelism. On the other hand, "almost parallel" doesn't include designed non-parallel between anode 5 and cathode 6.

It is preferable distance w between anode 5 and cathode 6 is 10mm or more and 50mm or less, from a viewpoint of efficient utilization of high-density plasma. The distance w of 10mm or more can make a magnetron magnetic field stably generate plasma. The distance of 50mm or less can reduce the plasma-generation space where low-density plasma is generated and a magnetron magnetic field is not formed, so that the gas doesn't pass through such a space. It is preferable that the lower limit of distance w is 13mm and the upper limit thereof is 30mm. With a general technique of facing target magnetron sputtering, the distance between electrodes facing to each other should be wide for forming films since the atom sputtered from the target on the cathode surface is required to reach the substrate. In our invention to form a film by the plasma CVD method, it is possible that the distance between electrodes facing to each other is rather narrow as far as the gas is sufficiently decomposed.

It is preferable that anode 5 and cathode 6 are provided almost perpendicularly to substrate-holding mechanism 2. Also, it is preferable that first gas supply nozzle 9 is provided so as to supply gas in a direction almost perpendicular to substrate-holding mechanism 2. Such provided gas supply nozzle can supply gas onto substrate 3 almost perpendicularly so that the decomposed gas is more likely to contact substrate 3, and therefore the film deposition rate can be improved with maximized gas use efficiency. The term "almost perpendicular" means that anode 5 and cathode 6 are designed to be disposed perpendicular to substrate-holding mechanism 2, or that first gas supply nozzle 9 is designed such that the gas flows perpendicularly to substrate-holding mechanism 2. "Almost perpendicular" accepts a production error making a slight difference of the nozzle from precise perpendicularity. On the other hand, "almost perpendicular" doesn't include designed non-perpendicular nozzle.

It is preferable that shortest distance d1 between anode 5 and substrate-holding mechanism 2 and cathode 6 as well as shortest distance d2 between cathode 6 and substrate-holding mechanism 2 are 50mm or more and 200mm or less. When shortest distances d1 and d2 are 50mm or more, heat damage by the heat radiation from an electrode to substrate 3 can be reduced while gasses more often contact to each other to enhance the gas decomposition efficiency. When shortest distances d1 and d2 are 200mm or less, the gas diffusion loss is reduced and films can be formed at a high film deposition rate.

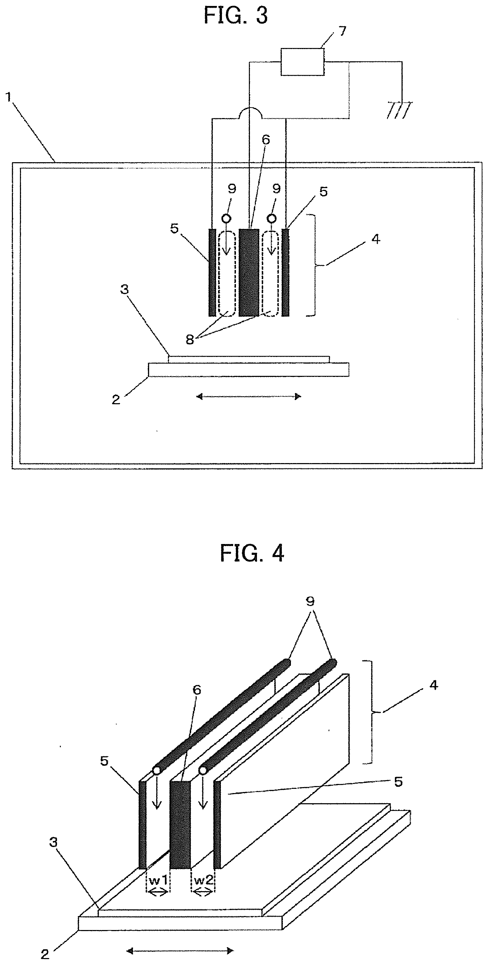

Fig. 3 is a schematic section view of another example of plasma CVD device. Plasma CVD electrode unit 4 is provided with two anodes 5 facing to each other and cathode 6 provided in a space between two anodes 5 at a distance. With such a configuration, two plasma-generation spaces 8 can be provided between anodes 5 and cathode 6 to utilize the surface area of cathode 6 at a maximum. As a result, plasma CVD electrode unit 4 can be provided compactly.

Fig. 4 is a perspective view of electrode unit of the plasma CVD electrode unit 4 shown in Fig. 3. As well as plasma CVD electrode unit 4 in Fig. 2, it is preferable that anodes 5 are provided almost parallel to cathode 6. As well as plasma electrode unit 4 in Fig. 2, it is preferable that distances w1 and w2 between anodes 5 and cathode 6 are 10mm or more, preferably 13mm or more. It is preferably that distances w1 and w2 are 50mm or less, preferably 30mm or less.

It is preferable that distance w1 is equal to w2, although they may be different from each other. When distance w1 is equal to w2, plasma can be generated at both sides of cathode 6 at the same stable intensity.

A raw material such as polymeric gas is introduced in to plasma CVD electrode unit 4. The polymeric gas by itself can generate a polymer, such as thin film and particle, by bonding active species generated by decomposing with plasma. The polymeric gas may be silane, disilane, TEOS (tetraethoxysilane), TMS (tetramethoxysilane), HMDS (hexamethyldisilazane), HMDSO (hexamethyl disiloxane), methane, ethane, ethylene, acetylene or the like. The polymeric gas can be used as a single gas or a mixture of gasses. Another gas other than the polymeric gas may be used as a raw material gas. The raw material gas may contain non-polymeric gas. The non-polymeric gas itself cannot generate a polymer by bonding active species generated by decomposing with plasma. The non-polymeric gas may be argon, oxygen, nitrogen, hydrogen, helium or the like.

It is preferable that first gas supply nozzle 9 is electrically insulated from cathode 6. When it is insulated electrically, abnormal discharge between first gas supply nozzle 9 and cathode 6 can be prevented from causing. Such an electrical insulation can prevent gas supply port 16 of first gas supply nozzle 9 from being obstructed with abnormal discharge.

It is preferable that first gas supply nozzle 9 extends in a direction parallel to substrate 3. Such a configuration makes it possible that a uniform film is formed on substrate 3 even when it has a large area.

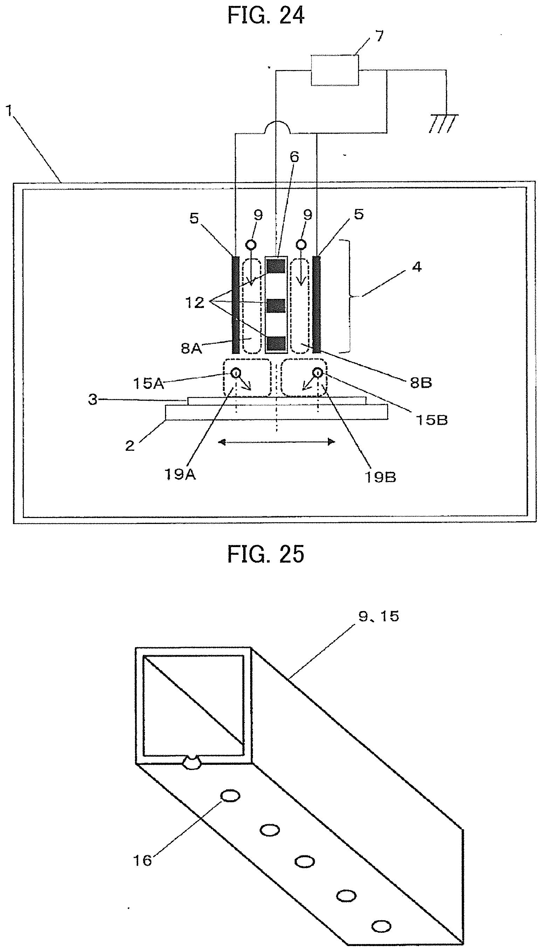

Fig. 25 is a schematic enlarged view of an example of gas supply nozzle such as first gas supply nozzle 9. First gas supply nozzle 9 is provided with a plurality of gas supply ports 16. To make the in-plane distribution of thin film on substrate 3 uniform, it is preferable that gas supply ports 16 supply the same amount of gas. Further, it is preferable that gas supply port 16 has a circular truncated corn shape in which a hole at the plasma-generation space side has a diameter larger than that of the other hole at inner side of the gas supply nozzle. When gas supply port 16 has a smaller opening diameter at inner side of the gas supply nozzle, gas flow rate flowing from the inner side of the gas supply nozzle to gas supply port 16 can be suppressed. Therefore the gas can be retained for a long time in first gas supply nozzle 9 to make the gas concentration distribution uniform in first gas supply nozzle 9. As a result, the supply rate of gas supplied through each gas supply port 16 can be kept uniformly. The raw material gas flowing out of gas supply port 16 is decomposed with plasma generated near gas supply port 16 and is deposited at gas supply port 16. However gas supply port 16 is not completely obstructed with such a deposition generated when gas supply port 16 has a larger diameter at the plasma-generation space side. As a result, the raw material gas can be continuously supplied to form a film stably for a long time.

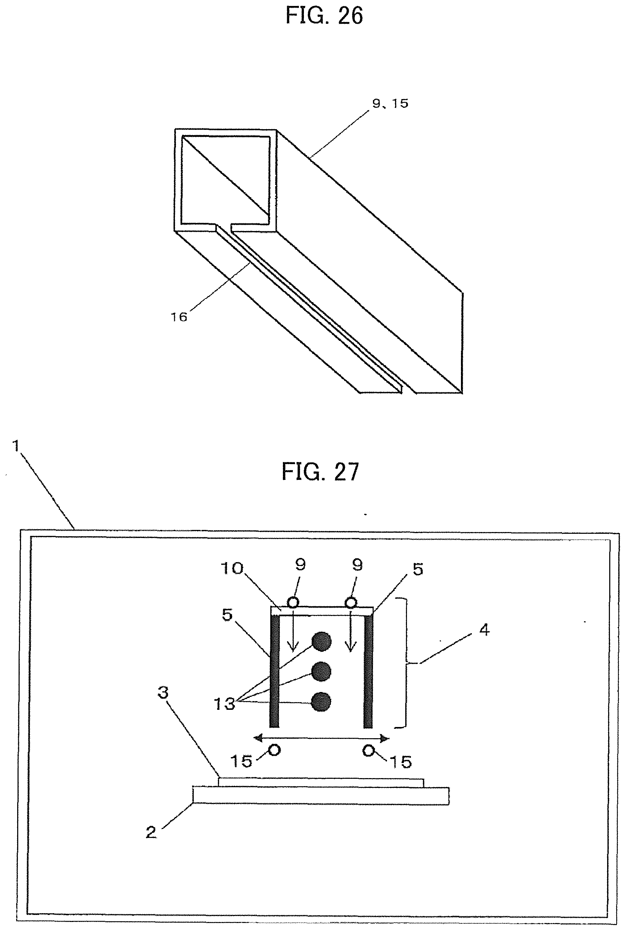

Fig. 26 is a schematic enlarged view of another example of gas supply nozzle such as first gas supply nozzle 9. First gas supply nozzle 9 is provided with a slit-shaped gas supply ports 16. The raw material gas ejected from gas supply port 16 is decomposed with plasma generated near first gas supply nozzle 9 and may be deposited at first gas supply nozzle 9 to partially obstruct gas supply port 16. The slit-shaped gas supply port 16 can continue to supply gas uniformly along the longitudinal direction of first gas supply nozzle 9 to form a film stably for a long time even when gas supply port 16 is partially obstructed.

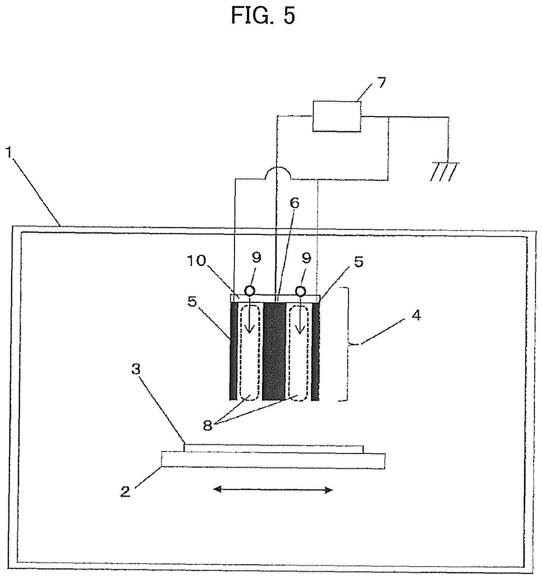

Fig. 5 is a schematic section view of another example of plasma CVD device. In this plasma CVD device, plasma CVD electrode unit 4 is provided with bottom plate 10 opposite to substrate-holding mechanism 2 as viewed from anode 5 and cathode 6. It is preferable that bottom plate 10 is provided to obstruct a space between anode 5 and cathode 6. Thus provided bottom plate 10 can orient the decomposed gas flow ejected from plasma CVD electrode unit 4 toward substrate-holding mechanism 2. It is preferable that bottom plate 10 is electrically insulated from cathode 6. When it is insulated electrically, abnormal discharge between bottom plate 10 and cathode 6 can be prevented from causing. Such an electrical insulation between bottom plate 10 and cathode 6 can prevent gas supply port 16 of first gas supply nozzle 9 from being obstructed with abnormal discharge, particularly in a case where bottom plate 10 incorporates first gas supply nozzle 9.

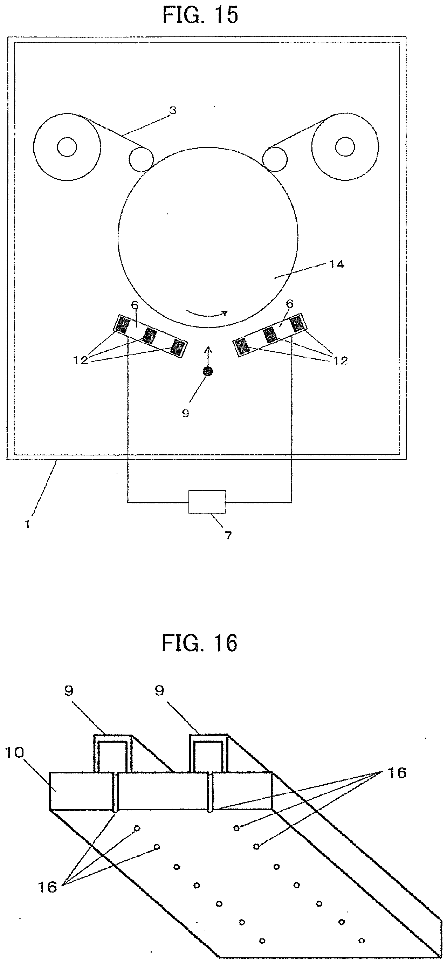

Fig. 16 is a perspective section view of an example of bottom plate 10 incorporating first gas supply nozzle 9. In this example, first gas supply nozzle 9 is joined to one side of bottom plate 10 while a plurality of gas supply ports 16 connecting first gas supply nozzle 9 and the other side of bottom plate 10 is provided through bottom plate 10. Gas is supplied from gas supply port 16 toward plasma-generation space 8. With such a configuration, the gas supplied from first gas supply nozzle 9 can pass through plasma-generation space 8 between anode 5 and cathode 6 without leaking to the rear side of first gas supply nozzle 9, so that gas utilization efficiency is improved.

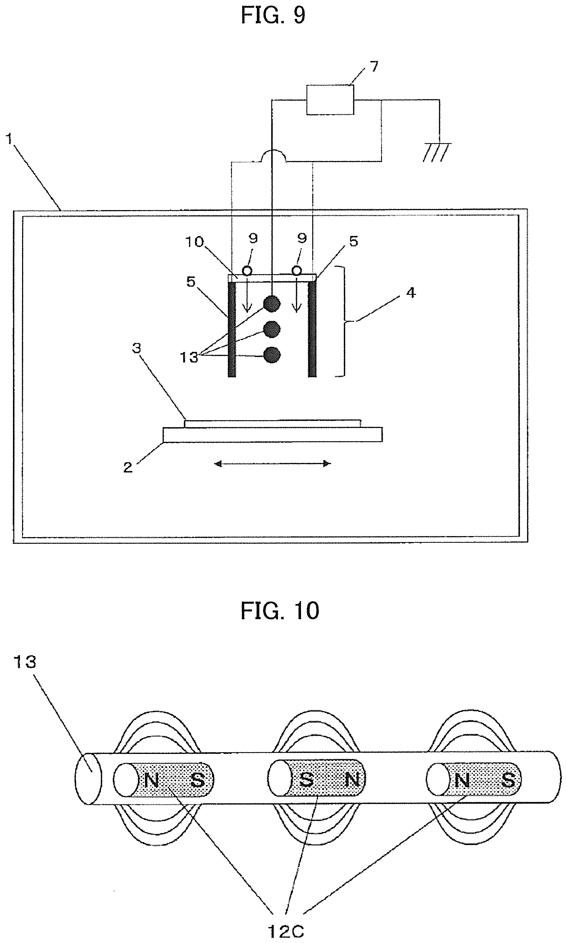

Cathode 6 may be constituted by two or more arrayed metal cylindrical electrodes. Fig. 9 is a schematic section view of an example of plasma CVD device having three metal cylindrical electrodes 13 arrayed as cathode 6. Such a plurality of metal cylindrical electrodes 13 can constitute cathode 6 compactly. The number of metal cylindrical electrodes 13 can be adjusted according to the size of plasma CVD electrode unit 4. Metal cylindrical electrodes 13 can be provided at different intervals depending on positions so that plasma density distribution is adjusted in plasma-generation space 8 to make the decomposition condition suitable for gaseous species. The plasma CVD device shown in Fig. 9 employs cathode 6 constituting a plurality of metal cylindrical electrodes 13 arrayed in a row in parallel to anode 5, although metal cylindrical electrodes 13 arrayed in two rows may constitute cathode 6. Metal cylindrical electrodes 13 arrayed in two or more rows can intentionally disturb the flow of gas ejected from first gas supply nozzle 9. As a result, the gas can be retained for a long time in plasma-generation space 8 to enhance the gas decomposition efficiency. It is preferable that all metal cylindrical electrodes 13 connected by conductive material to each other have the same electric potential. In the plasma CVD device shown in Fig. 9, three metal cylindrical electrodes 13 are connected by conductive material (not shown) to have the same electric potential.

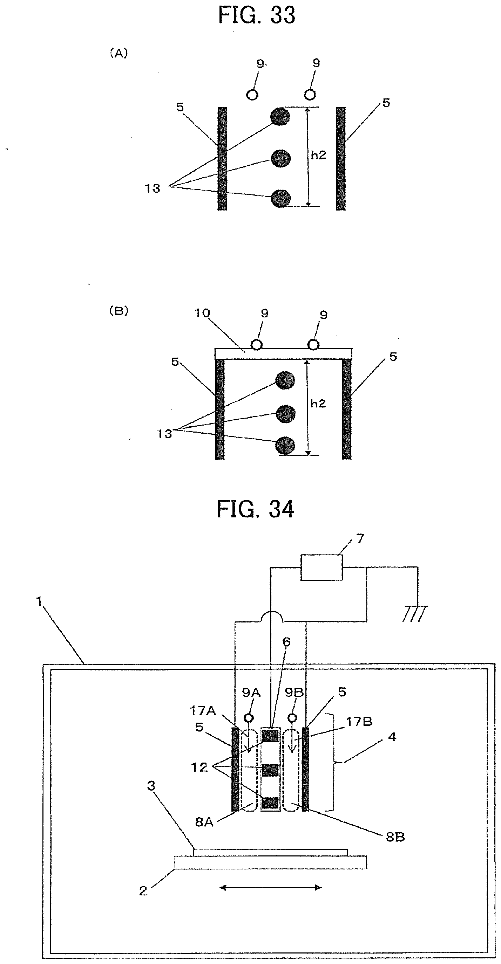

Cathode 6 is supposed to have height h2 as follows when cathode 6 consists of a plurality of arrayed metal cylindrical electrodes. When plasma CVD electrode unit 4 doesn't have bottom plate 10, height h2 of cathode 6 means a distance from the outer end face of a metal cylindrical electrode on one end to the outer end face of another metal cylindrical electrode on the other end, as shown in Fig. 33 (A). When plasma CVD electrode unit 4 has bottom plate 10, height h2 of cathode 6 means a distance from the outer end of metal cylindrical electrode 13 located furthest from bottom plate 10 to the surface of bottom plate 10 facing to metal cylindrical electrode 13, as shown in Fig. 33 (B).

Fig. 10 is an enlarged transparent view of metal cylindrical electrode 13. Inside metal cylindrical electrode 13, a plurality of magnets 12C may be inserted as generating repelling force between adjacent magnets 12C. Such inserted magnets 12C can generate high-density plasma called coaxial magnetron plasma with a magnetic field present outside the metal cylindrical, so that the gas decomposition efficiency improves. It is preferable that a coolant flows inside metal cylindrical electrode 13 in order to cool magnet 12C and metal cylindrical electrode 13 heated with plasma.

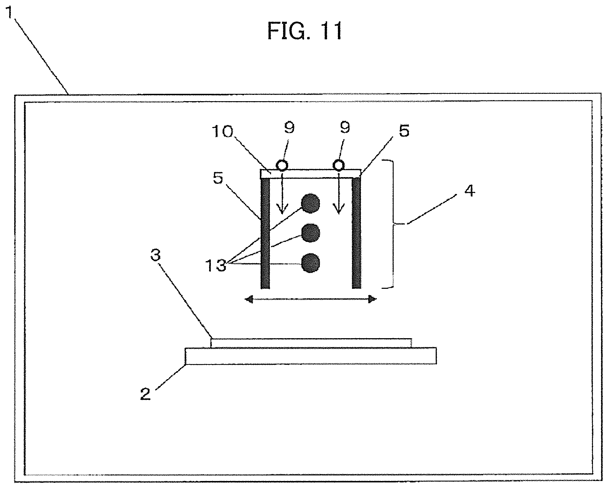

Fig. 11 is a schematic section view of another example of plasma CVD device. In this plasma CVD device, plasma CVD electrode unit 4 can move relative to substrate-holding mechanism 2 in a direction shown with a bidirectional arrow in Fig. 11. Such a configuration makes it possible that a film is formed on a whole surface of substrate 3 even when it has a large area. From a viewpoint of forming a uniform thin film on substrate 3, it is preferable that plasma CVD electrode unit 4 moves in a direction perpendicular to the longitudinal direction of plasma CVD electrode unit 4 and parallel to the plane of substrate 3.

Alternatively, it is possible that substrate-holding mechanism 2 moves relative to plasma CVD electrode unit 4. In Fig 1, Fig 2, Fig. 3, Fig. 4, Fig. 5, Fig. 6 and Fig. 9, bidirectional arrows show directions in which substrate-holding mechanism 2 moves relative to plasma CVD electrode unit 4. Such moving substrate-holding mechanism 2 makes it possible that a uniform film is formed on substrate 3 even when it has a large area. From a viewpoint of forming a uniform film on substrate 3, it is preferable that substrate-holding mechanism 2 moves in a direction perpendicular to the longitudinal direction of plasma CVD electrode unit 4 and parallel to the plane of substrate 3.

When substrate 3 is a long substrate, substrate-holding mechanism 2 can be moved relative to plasma CVD electrode unit 4 to continuously form a thin film on the surface of substrate 3 to enhance productivity. The long substrate may be a resin film made of polyethylene terephthalate (PET), polypropylene (PP), polystyrene, polyvinyl chloride, polyimide, Teflon (registered trademark) or the like, a metal foil such as aluminum foil, copper foil and stainless steel foil or the like.

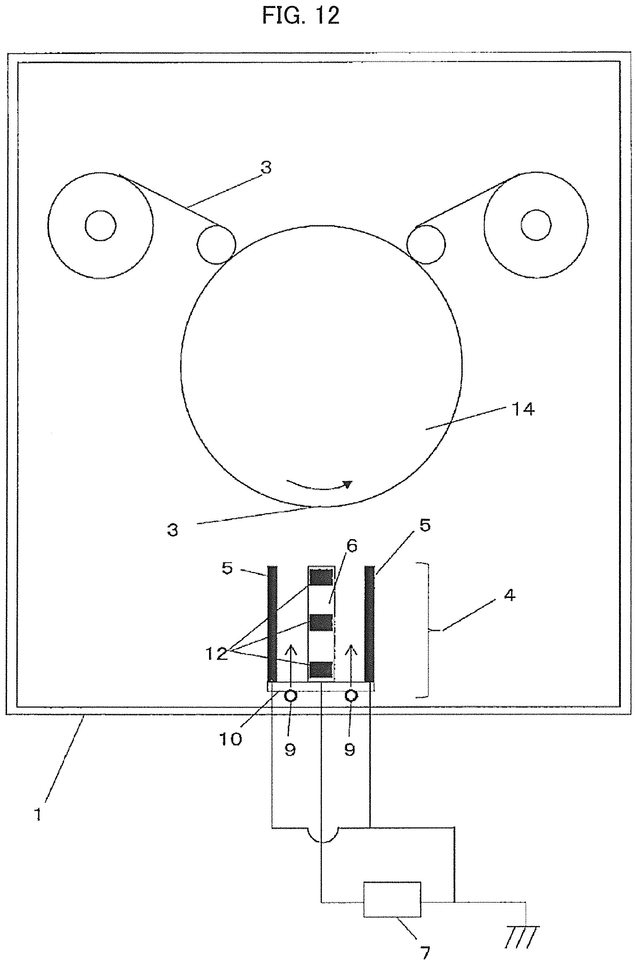

Fig. 12 is a schematic section view of yet another example of plasma CVD device. In this plasma CVD device, cylindrical drum 14 is employed as substrate-holding mechanism 2 and long substrate 3 is moved by cylindrical drum 14 rotating as contacting the substrate on the surface. With such a configuration, a film can be formed continuously on the surface of long substrate 3 stably running without flapping of long substrate 3. Because the film can be formed as cooling cylindrical drum 14 to make long substrate 3 remove heat given at the time of film formation, so that the film is stably formed.

It is possible that the plasma CVD device is provided with a second gas supply nozzle other than the first gas supply nozzle. In the method disclosed in Patent document 2, a degradable oxidation gas is mixed with an ionized gas for electric discharge and the mixed gas is ejected from the gas supply section, and therefore the film quality of thin film is not sufficiently controlled. In the method disclosed in Patent document 3, the in-plane supply amount of gas supplied from the ejection hole cannot be controlled, so that the film quality of thin film is not sufficiently controlled. The film quality of thin film can be sufficiently controlled with the following plasma CVD device provided with a second gas supply nozzle.

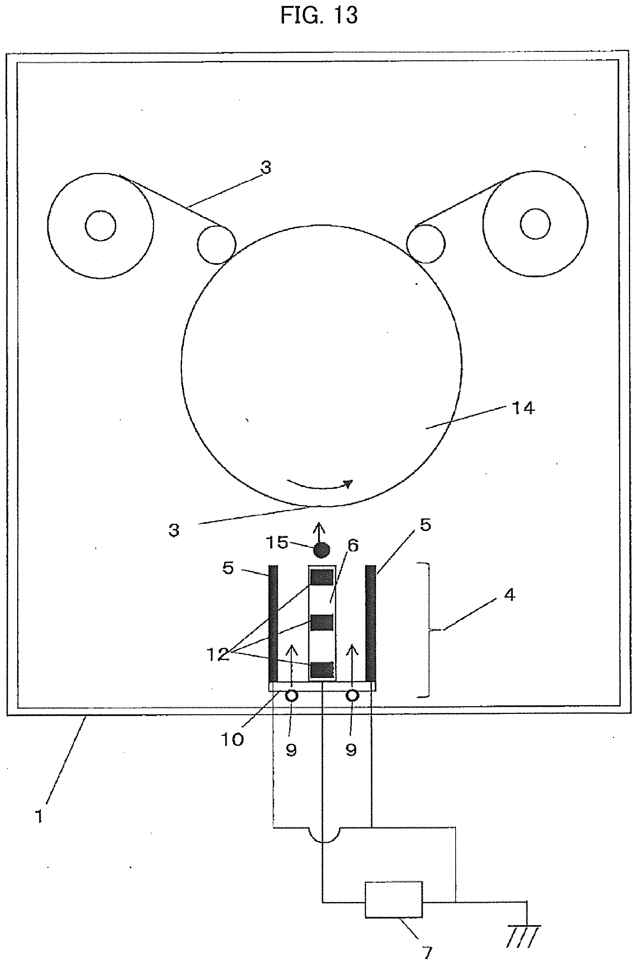

Fig. 13 is a schematic section view of yet another example of plasma CVD device. This plasma CVD device is provided with second gas supply nozzle 15 supplying gas without passing through a plasma-generation space. Specifically, second gas supply nozzle 15 is provided in a space between cathode 6 and substrate-holding mechanism 2. Such configured nozzle can supply different gasses to first gas supply nozzle 9 and second gas supply nozzle 15. For example, it is possible that a polymeric gas such as silane gas (SiH₄), methane (CH₄) and hexamethyl disiloxane (HMDSO) is supplied from second gas supply nozzle 15 while a non-polymeric gas such as argon and oxygen is supplied from first gas supply nozzle 9 toward substrate-holding mechanism 2 through plasma-generation space 8 between anode 5 and cathode 6 to efficiently deliver the decomposed gas to the surface of substrate 3. Because first gas supply nozzle 9 is close to plasma-generation space 8, first gas supply nozzle 9 might be obstructed with polymerized film attached when the polymeric gas is supplied through first gas supply nozzle 9 in a certain film formation condition. When the non-polymeric gas is supplied through first gas supply nozzle 9 while the polymeric gas is supplied through second gas supply nozzle 15, first gas supply nozzle 9 cannot be obstructed as such. Further, the polymeric gas as a raw material of films can be supplied from second gas supply nozzle 15 to the neighborhood of substrate 3 at a high concentration to improve the film deposition rate and flexibility of film quality control. Furthermore, a space in which the non-polymeric gas is decomposed in plasma-generation space 8 can be separated from another space in which the decomposed gas reacts with the polymeric gas supplied through second gas supply nozzles 15A and 15B, so that the gas reaction is controlled to improve the flexibility of film quality control.

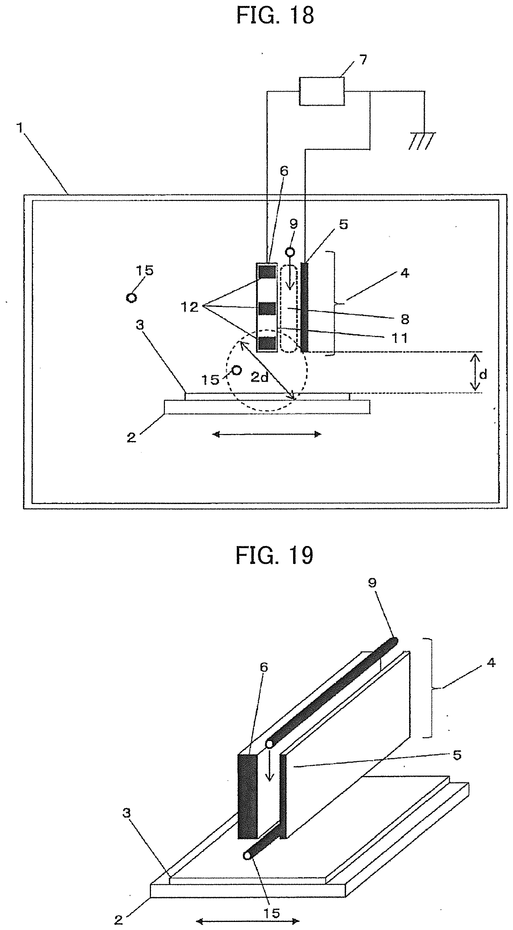

As shown in Fig. 18, it is preferable that second gas supply nozzle 15 is provided in a region surrounded by a circle having diameter of 2d around the center of the shortest distance d between substrate-holding mechanism 2 and anode 5 or cathode 6, from a viewpoint of efficient gas supply to substrate 3. It is more preferable that second gas supply nozzle 15 is provided in a space between cathode 6 and substrate-holding mechanism 2.

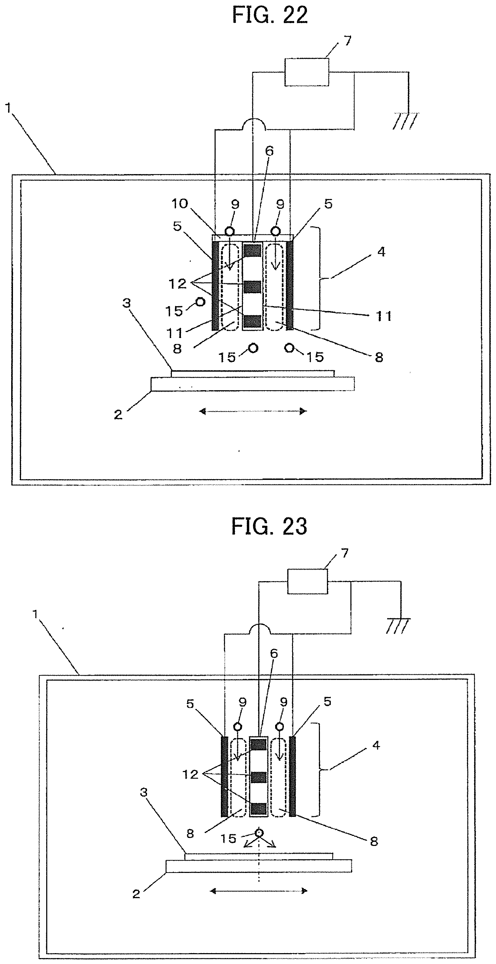

Fig. 23 is a schematic section view of another example of plasma CVD device. This plasma CVD device is provided with second gas supply nozzle 15 in a space between cathode 6 and substrate-holding mechanism 2. Second gas supply nozzle 15 is provided with a plurality of gas supply ports 16. At least one of the gas supply ports 16 has a gas-supply direction inclined toward the plasma-generation space side from the plane which includes the second gas supply nozzle and is perpendicular to substrate-holding mechanism 2, as shown with unidirectional arrows in Fig. 23. With such a configuration, second gas supply nozzle 15 can efficiently supply a gas to mix with another gas ejected from first gas supply nozzle 9 and decomposed in plasma-generation space 8, so that the flexibility of film quality control is improved.

Fig. 24 is a schematic section view of another example of plasma CVD device. This plasma CVD device is provided with second gas supply nozzles 15A and 15B in spaces 19A and 19B, which is surrounded by substrate-holding mechanism 2 and anodes 5 and is divided by the plane which includes cathode 6 and is perpendicular to substrate-holding mechanism 2. With such a configuration, the gas can be efficiently supplied to plasma-generation spaces 8A and 8B to mix with each decomposed gas therein between anodes 5 and cathode 6. Further, the film quality can be controlled individually in each space 19A and 19B by supplying gasses through second gas supply nozzles 15A and 15B by different supply rate, so that the flexibility of film quality is improved. Furthermore, second gas supply nozzles 15A and 15B can supply different kind of gasses to control the film quality individually in each space 19A and 19B, so that the flexibility of film quality is improved.

Fig. 25 and Fig. 26 are schematic enlarged views of examples of gas supply nozzle such as second gas supply nozzle 15. Second gas supply nozzle 15 has the same characteristics as first gas supply nozzle 9 shown in Fig. 25 and Fig. 26.

Next, the plasma CVD method will be explained. The plasma CVD method with the above-described plasma CVD device comprises holding the substrate with substrate-holding mechanism 2, generating plasma in plasma-generation space 8, supplying gas from first gas supply nozzle 9 through the plasma-generation space toward substrate 3, forming a thin film on the surface of substrate 3. With such a configuration, a uniform thin film can be formed at a high speed even when substrate 3 has a large area. It is preferable that first gas supply nozzle 9 supplies a polymeric gas of which molecule has Si atom and/or C atom.

The plasma CVD method with plasma CVD device shown in Fig. 34 comprises supplying different kinds of polymeric gases 17A and 17B from first gas supply nozzles 9A and 9B to each space between cathode 6 and two facing anodes 5, generating plasma in plasma-generation spaces 8A and 8B, forming a thin film on the surface of substrate 3 held with substrate-holding mechanism 2. This method can make two different kinds of thin films with a single plasma CVD electrode unit 4 at the same time. Substrate-holding mechanism 2 can be moved in a direction perpendicular to the longitudinal direction of plasma CVD electrode unit 4 while a film is formed, so that two different kinds of thin films are deposited continuously with the single plasma CVD electrode unit 4.

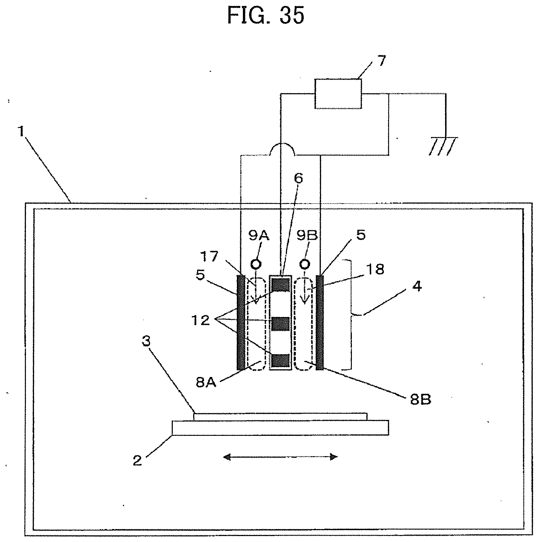

The plasma CVD method with plasma CVD device shown in Fig. 35 comprises supplying non-polymeric gas 18 from first gas supply nozzle 9B to one space between cathode 6 and anode 5 and polymeric gas 17 from first gas supply nozzle 9A to the other space between cathode 6 and anode 5, generating plasma in plasma-generation spaces 8A and 8B, forming a thin film on the surface of substrate 3 held with substrate-holding mechanism 2. By this method, single plasma CVD electrode unit 4 can modify the surface of substrate 3 with plasma generated with non-polymeric gas 18 and deposit a thin film with polymeric gas 17 at the same time. Substrate-holding mechanism 2 can be moved in a direction perpendicular to the longitudinal direction of plasma CVD electrode unit 4 while a film is formed, so that a thin film is deposited and the surface modification is performed continuously with the single plasma CVD electrode unit 4.

The plasma CVD method with plasma CVD device having the second gas supply nozzle comprises holding substrate 3 with substrate-holding mechanism 2, generating plasma in plasma-generation space 8, supplying a gas from first gas supply nozzle 9 through plasma-generation space 8 toward substrate 3, supplying another gas from second gas supply nozzle 15 without passing through plasma-generation space 8 toward substrate 3, forming a thin film on the surface of substrate 3.

In the plasma CVD device shown in Fig. 13, it is preferable that first gas supply nozzle 9 supplies a non-polymeric gas while second gas supply nozzle 15 supplies a polymeric gas of which molecule has Si atom and/or C atom, plasma is generated in a plasma-generation space and a thin film is formed on the surface of substrate 3. With such a gas supply configuration, first gas supply nozzle 9 can be prevented from obstructing by excluding the polymeric gas from the neighborhood of first gas supply nozzle 9 positioned close to the plasma-generation space. Further, the polymeric gas supplied through second gas supply nozzle 15 effectively reacts with the decomposed gas flowing out of the plasma-generation space, so that the polymeric gas is decomposed and delivered onto the surface of substrate 3 to form a thin film efficiently. Furthermore, a space in which the non-polymeric gas is decomposed in plasma-generation space 8 can be separated from another space in which the decomposed gas reacts with the polymeric gas supplied through second gas supply nozzle 15, so that the gas reaction is controlled to improve the flexibility of film quality control.

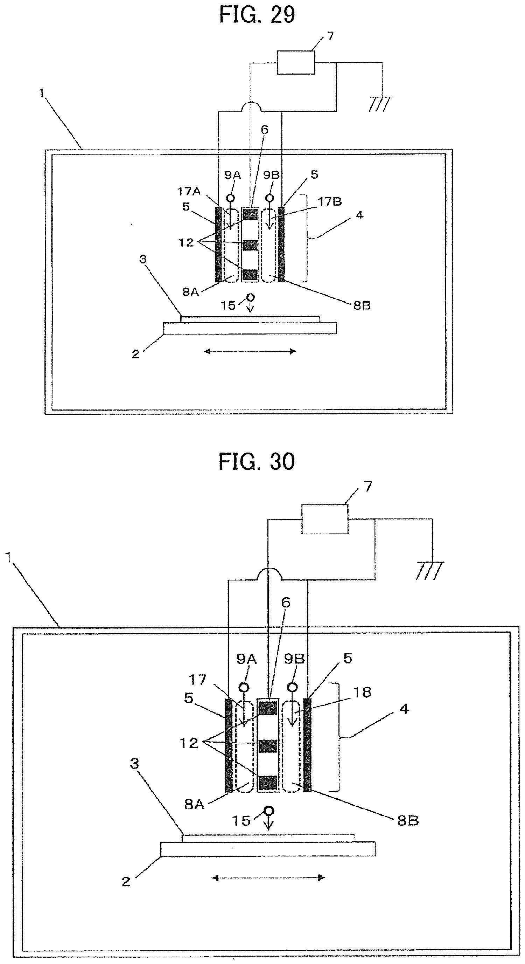

The plasma CVD method with plasma CVD device shown in Fig. 29 comprises supplying different kinds of polymeric gases 17A and 17B through first gas supply nozzles 9A and 9B to each space between cathode 6 and two facing anodes 5, generating plasma in plasma-generation spaces 8A and 8B, forming a thin film on the surface of substrate 3 held with substrate-holding mechanism 2. This method can make two different kinds of thin films with a single plasma CVD electrode unit 4 at the same time. Substrate-holding mechanism 2 can be moved in a direction perpendicular to the longitudinal direction of plasma CVD electrode unit 4 while a film is formed, so that two different kinds of thin films are deposited continuously with the single plasma CVD electrode unit 4.

The plasma CVD method with plasma CVD device shown in Fig. 30 comprises supplying non-polymeric gas 18 from first gas supply nozzle 9B to one space between cathode 6 and anode 5 and polymeric gas 17 from first gas supply nozzle 9A to the other space between cathode 6 and anode 5, generating plasma in plasma-generation spaces 8A and 8B, forming a thin film on the surface of substrate 3 held with substrate-holding mechanism 2. By this method, a single plasma CVD electrode unit 4 can modify the surface of substrate 3 with plasma generated with non-polymeric gas 18 and deposit a thin film with polymeric gas 17 at the same time. Substrate-holding mechanism 2 can be moved in a direction perpendicular to the longitudinal direction of plasma CVD electrode unit 4 while a film is formed, so that a thin film is deposited and the surface modification is performed continuously with the single plasma CVD electrode unit 4.

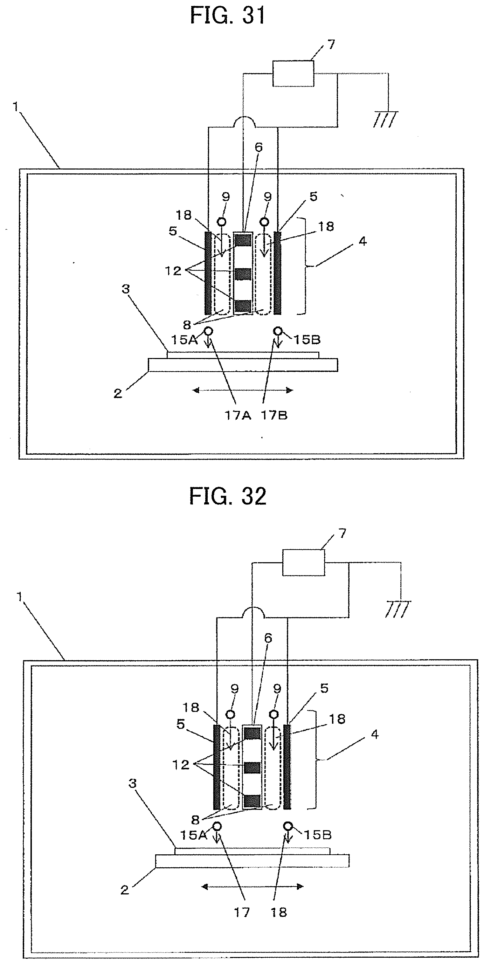

The plasma CVD method with plasma CVD device shown in Fig. 31 comprises supplying different kinds of polymeric gases 17A and 17B through second gas supply nozzles 15A and 15B, generating plasma in plasma-generation space 8, forming a thin film on the surface of substrate 3 held with substrate-holding mechanism 2. This method can make two different kinds of thin films with a single plasma CVD electrode unit 4 at the same time. Substrate-holding mechanism 2 can be moved in a direction perpendicular to the longitudinal direction of plasma CVD electrode unit 4 while a film is formed, so that two different kinds of thin films are deposited continuously with the single plasma CVD electrode unit 4. It is possible that first gas supply nozzle 9 supplies non-polymeric gas 18 to form a film so that first gas supply nozzle 9 can be prevented from obstructing by excluding the polymeric gas from the neighborhood of first gas supply nozzle 9 positioned close to the plasma-generation space. Further, polymeric gases 17A and 17B supplied through second gas supply nozzles 15A and 15B effectively react with the decomposed gas flowing out of plasma-generation space 8, so that polymeric gases 17A and 17B are decomposed and delivered onto the surface of substrate 3 to form a thin film efficiently. Furthermore, a space in which the non-polymeric gas is decomposed in plasma-generation space 8 can be separated from another space in which the decomposed gas reacts with the polymeric gases supplied through second gas supply nozzles 15A and 15B, so that the gas reaction is controlled to improve the flexibility of film quality control.

In the plasma CVD method with the plasma CVD device shown in Fig. 32, it is possible that second gas supply nozzle 15A supplies polymeric gas 17 while second gas supply nozzle 15B supplies non-polymeric gas 18, plasma is generated in plasma-generation space 8 and a thin film is formed on the surface of substrate 3 held with substrate-holding mechanism 2. By this method, a single plasma CVD electrode unit 4 can modify the surface of substrate 3 with plasma generated with non-polymeric gas 18 and deposit a thin film with polymeric gas 17 at the same time. Substrate-holding mechanism 2 can be moved in a direction perpendicular to the longitudinal direction of plasma CVD electrode unit 4 while a film is formed, so that a thin film is deposited and the surface modification is performed continuously with the single plasma CVD electrode unit 4. When non-polymeric gas 18 is supplied through first gas supply nozzle 9 as a film is formed, first gas supply nozzle 9 can be prevented from obstructing by excluding the polymeric gas from the neighborhood of first gas supply nozzle 9 positioned close to the plasma-generation space. Further, polymeric gas 17 supplied through second gas supply nozzle 15A effectively reacts with the decomposed gas flowing out of plasma-generation space 8, so that polymeric gas 17 is decomposed and delivered onto the surface of substrate 3 to form a thin film efficiently. Furthermore, a space in which the non-polymeric gas is decomposed in plasma-generation space 8 can be separated from another space in which the decomposed gas reacts with the polymeric gas supplied through second gas supply nozzles 15A and 15B, so that the gas reaction is controlled to improve the flexibility of film quality control.

In the plasma CVD method, it is preferable that a polymeric gas of which molecule has Si atom and/or C atom, such as silane gas (SiH₄), methane (CH₄) and hexamethyl disiloxane (HMDSO), is supplied while a non-polymeric gas such as argon and oxygen is supplied to generate plasma in plasma-generation space 8 to form a thin film on the surface of substrate 3 held with substrate-holding mechanism 2. Such a method can improve gas use efficiency, film deposition rate of polymerized films and flexibility of film quality control.

### [Examples]

Next, thin films formed with the plasma CVD device will be explained with Examples.

### [Example 1]

A thin film was formed with the plasma CVD device shown in Fig. 3 and Fig. 4. Length h1 of anodes 5 in the gas-supply direction and length h2 of cathode 6 in the gas-supply direction were 100mm, wherein anode 5 was provided almost in parallel with cathode 6. Distances w1 and w2 between anodes 5 and cathode 6 were 20mm. Shortest distance d1 between anode 5 and substrate-holding mechanism 2 and shortest distance d2 between cathode 6 and substrate-holding mechanism 2 were 100mm. A glass plate having thickness of 3mm was employed as substrate 3. First gas supply nozzle 9 supplied mixed gas of 50sccm of HMDSO (hexamethyl disiloxane) and 500sccm of oxygen. The vacuum chamber inner pressure was adjusted to 10Pa with a pressure-regulating mechanism (not shown). High-frequency electricity of 100 kHz was applied with power supply 7 to cathode 6 to set electricity to 1kW. A thin film was formed on the surface of substrate 3 while substrate 3 was moved horizontally at speed of 0.1m/min in a direction perpendicular to the longitudinal direction of plasma CVD electrode unit 4.

The thickness of formed thin film was measured with a step height meter (ET-10 made by Kosaka Laboratory Ltd). The measured thickness was multiplied by the feeding speed of substrate 3 to obtain a film thickness (dynamic rate [nm·m/min]) when the substrate is fed to form a film at a unit speed. The high-speed film formation performance was graded according to the dynamic rate, wherein 100nm·m/min or more is graded as "Excellent" means and less than 100nm·m/min is graded as "Poor". The dynamic rate was 100nm·m/min while the high-speed film formation performance was "Excellent".

### [Example 2]

A thin film was formed with the plasma CVD device shown in Fig. 5. Plasma CVD electrode unit 4 had the same configuration as Example 1, except for having bottom plate 10. A thin film was formed on the surface of substrate 3 in the same film formation condition as Example 1. The dynamic rate was 125nm-m/min while the high-speed film formation performance was "Excellent".

### [Example 3]

A thin film was formed with the plasma CVD device shown in Fig. 6. Plasma CVD electrode unit 4 had the same configuration as Example 2, except that cathode 6 incorporates magnet 12 to form a magnetron magnetic field on plasma-generation surface 11. A thin film was formed on the surface of substrate 3 in the same film formation condition as Example 1.

The dynamic rate was 150nm·m/min as an extremely high speed of film formation while the high-speed film formation performance was "Excellent".

### [Example 4]

A thin film was formed with the plasma CVD device shown in Fig. 9. Plasma CVD electrode unit 4 had the same configuration as Example 2, except that the cathode consists of three metal cylindrical electrodes 13. Metal cylindrical electrodes 13 had diameter of 12mm and permanent magnets 12C inside were inserted in metal cylindrical electrode 13 as shown in Fig. 10. Coolant was flowed inside metal cylindrical electrode 13 for cooling metal cylindrical electrode 13 and internal magnets 12C. Length h2 (distance from the outer end of metal cylindrical electrode 13 located furthest from bottom plate 10 to the surface of bottom plate 10 facing to metal cylindrical electrode 13) of cathode in the gas-supply direction was 100mm. A thin film was formed on the surface of substrate 3 in the same film formation condition as Example 1.

The dynamic rate was 115nm·m/min while the high-speed film formation performance was "Excellent".

### [Example 5]

A thin film was formed on the surface of long substrate 3 with the plasma CVD device shown in Fig. 12. Plasma CVD electrode unit 4 had the same configuration as Example 3. PET film ("Lumirror" made by Toray Industries, Inc.) of thickness 100µm was employed as long substrate 3. Long substrate 3 was fed as adhering to the surface of cylindrical drum 14 rotating at speed of 1m/min to form a thin film on the surface of long substrate 3. A thin film was formed in the same film formation condition as Example 1.

The dynamic rate was 145nm·m/min as an extremely high speed of film formation while the high-speed film formation performance was "Excellent".

Even 30min after starting the continuous film formation, the discharge stability was good since electric discharge fluctuation as a sign of abnormal discharge was not visually observed.

90min after starting the continuous film formation, a slight electric discharge fluctuation was visually observed. The electrode was visually observed after 90min continuous film formation to find a thin film adhered to cathode 6 and first gas supply nozzle 9.

Any thermal damage caused by the film formation was not observed on long substrate 3 which formed the thin film.

### [Comparative Example 1]

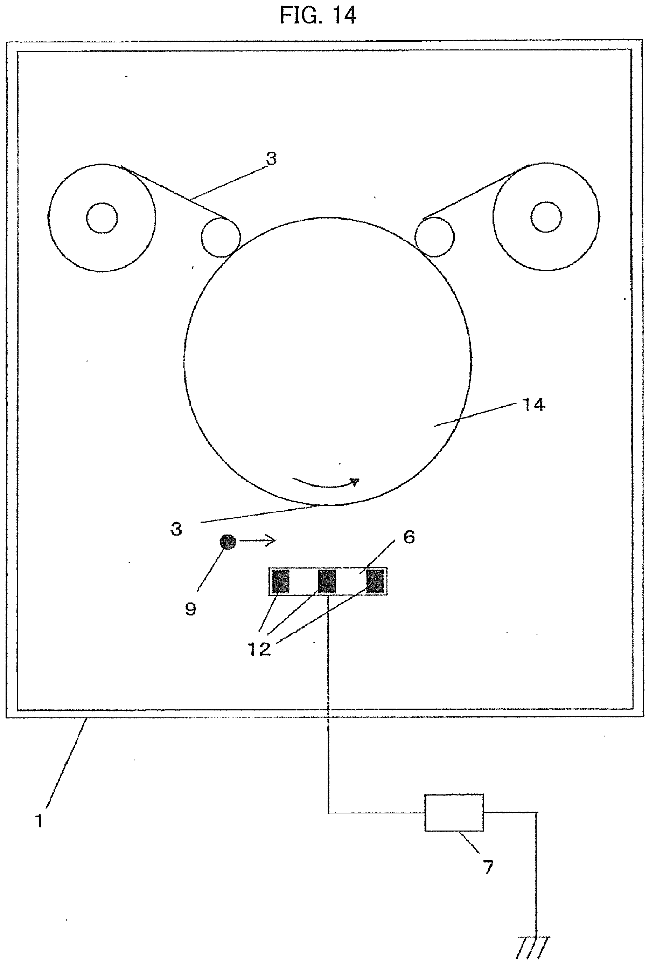

A thin film was formed on the surface of long substrate 3 with the plasma CVD device shown in Fig. 14. Plasma CVD electrode unit 4 had the discharge surface of planar magnetron-type cathode 6 facing long substrate 3, and first gas supply nozzle 9 provided upstream in the feeding direction of long substrate 3. PET film ("Lumirror" made by Toray Industries, Inc.) of thickness 100µm was employed as long substrate 3. Long substrate 3 was fed as adhering to the surface of cylindrical drum 14 rotating at speed of 1m/min to form a thin film on the surface of long substrate 3. A thin film was formed in the same film formation condition as Example 1.

The dynamic rate was 20nm·m/min while the high-speed film formation performance was "Poor". About 20min after starting the continuous film formation, the discharge stability was unstable since electric discharge fluctuation as a sign of abnormal discharge was visually observed. The electrode was visually observed after about 20min continuous film formation to find a thin film formed on cathode 6 and first gas supply nozzle 9.

A thermal damage caused by the film formation was observed on long substrate 3 which formed the thin film.

### [Comparative Example 2]

A thin film was formed on the surface of long substrate 3 with the plasma CVD device shown in Fig. 15. Plasma CVD electrode unit 4 had two pieces of cathodes 6 insulated electrically from each other. Two pieces of cathodes 6 incorporated magnets 12 to form a magnetron magnetic field. Each of cathodes 6 was provided close to long substrate 3 facing the magnetron discharge surface. First gas supply nozzle 9 was provided between two pieces of cathodes 6. Power supply 7 was connected to two pieces of cathodes 6 so that a high-frequency electric field was applied between two pieces of cathodes 6. PET film ("Lumirror" made by Toray Industries, Inc.) of thickness 100µm was employed as long substrate 3. Long substrate 3 was fed as adhering to the surface of cylindrical drum 14 rotating at speed of 1m/min to form a thin film on the surface of long substrate 3. A thin film was formed in the same film formation condition as Example 1.

The dynamic rate was 25nm·m/min while the high-speed film formation performance was "Poor". About 30min after starting the continuous film formation, the discharge stability was unstable since electric discharge fluctuation as a sign of abnormal discharge was visually observed. The electrode was visually observed after about 30min continuous film formation to find a thin film formed on cathode 6 and first gas supply nozzle 9.

A thermal damage caused by the film formation was observed on long substrate 3 which formed the thin film.

### [Example 6]

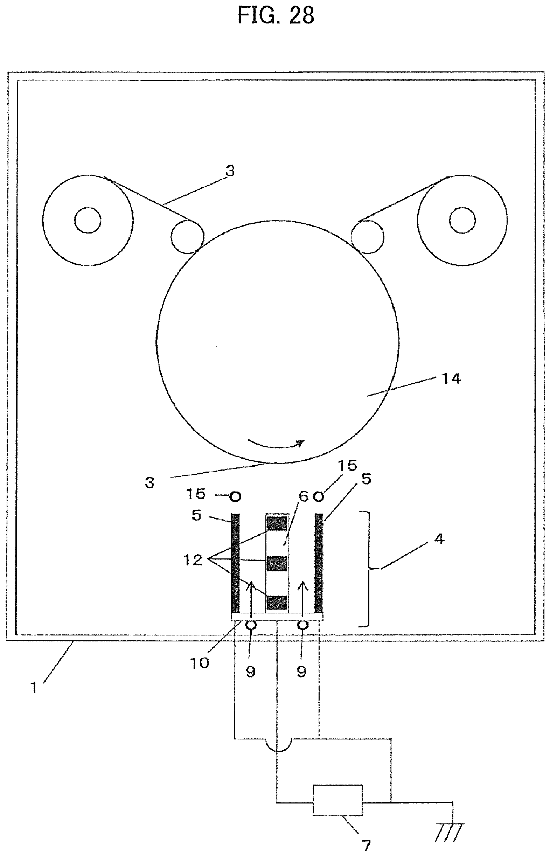

A thin film was formed on the surface of long substrate 3 with the plasma CVD device shown in Fig. 28. Length h1 of anodes 5 in the gas-supply direction and length h2 of cathode 6 in the gas-supply direction were 100mm, wherein anode 5 was provided almost in parallel with cathode 6. Distances w1 and w2 between anodes 5 and cathode 6 were 20mm. Shortest distance d1 between anode 5 and substrate-holding mechanism 2 and shortest distance d2 between cathode 6 and substrate-holding mechanism 2 were 100mm. PET film ("Lumirror" made by Toray Industries, Inc.) of thickness 100µm was employed as long substrate 3. First gas supply nozzle 9 supplied 1,000sccm of oxygen while second gas supply nozzle 15 supplied 10sccm of HMDSO (hexamethyl disiloxane). The vacuum chamber inner pressure was adjusted to 5Pa with a pressure-regulating mechanism (not shown). High-frequency electricity of 100 kHz was applied with power supply 7 to cathode 6 to set electricity to 1kW. Long substrate 3 was fed at speed of 1m/min as adhering to the surface of cylindrical drum 14 rotating to form a thin film on the surface of long substrate 3.

The dynamic rate was 110nm·m/min while the high-speed film formation performance was "Excellent". Even 90min after starting the continuous film formation, the discharge stability was good since electric discharge fluctuation as a sign of abnormal discharge was not visually observed. The electrode was visually observed after 90min continuous film formation to find no thin film adhered to cathode 6 or first gas supply nozzle 9.

Any thermal damage caused by the film formation was not observed on long substrate 3 which formed the thin film.

### Industrial Applications of the Invention

Our invention is applicable to plasma surface processing devices and plasma etching devices as well as plasma CVD devices, although applications are not limited to them.

### Explanation of symbols

1: vacuum chamber
2: substrate-holding mechanism
3: substrate
4: plasma CVD electrode unit
5: anode
6: cathode
7: power supply
8, 8A, 8B: plasma-generation space
9, 9A, 9B: first gas supply nozzle
10: bottom plate
11: plasma-generation surface
12, 12A, 12B, 12C: magnet
13: metal cylindrical electrode
14: cylindrical drum
15, 15A, 15B, 15C: second gas supply nozzle
16: gas supply port
17, 17A, 17B: polymeric gas
18: non-polymeric gas
19A, 19B: space between cathode and substrate-holding mechanism

## Claims

1. A plasma CVD device comprising a plasma CVD electrode unit (4) and a substrate-holding mechanism (2) in a vacuum chamber (1), wherein the plasma CVD electrode unit (4) comprises:
an anode (5);
a cathode (6) facing the anode (5) at a distance; and
a first gas supply nozzle (9) arranged to supply a gas through a plasma-generation space (8) between the anode (5) and the cathode (6),
the substrate-holding mechanism (2) being provided at a position to contact in use the gas passing through the plasma-generation space (8),
wherein a gas-supply directional length of the anode (5) and a gas-supply directional length of the cathode (6) are longer than a distance between the anode (5) and cathode **characterised in that** the plasma CVD electrode unit (4) further comprises a second gas supply nozzle (15) arranged to supply another gas without passing through the plasma-generation space (8), and
the second gas supply nozzle (15) is provided in a space (19A, 19B) between the cathode (6) and the substrate-holding mechanism (2).

2. The plasma CVD device according to claim 1, wherein the cathode (6) has a plasma-generation surface (11) on a side facing to the anode (5) and a magnet (12) inside which forms a magnetron magnetic field on the plasma-generation surface (11).

3. The plasma CVD device according to claim 1, wherein the cathode is constituted by two or more arrayed metal cylindrical electrodes in the gas-supply direction and a plurality of magnets are inserted inside the metal cylindrical electrode.

4. The plasma CVD device according to any one of claims 1 to 3, wherein the plasma CVD electrode unit (4) comprises two facing anodes (5) and the cathode (6) provided at a distance from the anodes (5) in a space between the anodes (5).

5. The plasma CVD device according to any one of claims 1 to 4, wherein the gas-supply directional length of the cathode (6) is 50mm to 300mm.

6. The plasma CVD device according to any one of claims 1 to 5, wherein a distance between the anode (5) and the cathode (6) is 13mm to 30mm.

7. The plasma CVD device according to any one of claims 1 to 6, wherein a shortest distance between the anode (5) and the substrate-holding mechanism (2) and another shortest distance between the cathode (6) and the substrate-holding mechanism (2) are 50mm to 200mm.

8. The plasma CVD device according to any one of claims 1 to 7, wherein the plasma CVD electrode unit (4) is provided with a bottom plate (10) opposite to the substrate-holding mechanism (2) as viewed from the anode (5) and the cathode (6),
the bottom plate (10) being electrically insulated from the cathode (6) and provided with the first gas supply nozzle (9).

9. The plasma CVD device according to any of claims 1 to 8, wherein the second gas supply nozzle (15) is provided with a plurality of gas supply ports (16),
at least one of the gas supply ports (16) having a gas-supply direction inclined toward the plasma-generation space side from a plane which includes the second gas supply nozzle (15) and is perpendicular to the substrate-holding mechanism (2).

10. The plasma CVD device according to any of claims 1 to 8, wherein the plasma CVD electrode unit (4) comprises two facing anodes (5) and the cathode (6) provided at a distance from the anodes (5) in a space between the anodes (5),
the second gas supply nozzle (15) being provided in each space which is surrounded by the two anodes (5) and the substrate-holding mechanism (2) and is divided by a plane which includes the cathode (6) and is perpendicular to the substrate-holding mechanism (2).

11. A plasma CVD method performed with the plasma CVD device according to any one of claims 1 to 10, comprising:
holding a substrate (3) with the substrate-holding mechanism (2);
generating a plasma in the plasma-generation space (8);
supplying a gas from the first gas supply nozzle (9) through the plasma-generation space (8) toward the substrate (3);
supplying another gas from the second gas supply nozzle (15) without passing through the plasma-generation space (8); and
forming a thin film on the substrate (3).

12. The plasma CVD method according to claim 11, further comprising:
supplying a non-polymeric gas (18) from the first gas supply nozzle (9); and
supplying a polymeric gas (17) from the second gas supply nozzle (15).

13. The plasma CVD method according to claim 11, wherein the plasma CVD electrode unit (4) comprises two facing anodes (5) and the cathode (6) provided at a distance from the anodes (5) in a space between the anodes (5), further comprising:
supplying a kind of polymeric gas (17A) from a first gas supply nozzle (9A) to one plasma-generation space (8A) between the cathode (6) and one anode (5); and
supplying another kind of polymeric gas (17B) from another first gas supply nozzle (9B) to the other plasma-generation space (8B) between the cathode (6) and the other anode (5).

14. The plasma CVD method according to claim 11, wherein the plasma CVD electrode unit (4) comprises two facing anodes (5) and the cathode (6) provided at a distance from the anodes (5) in a space between the anodes (5), further comprising:
supplying a non-polymeric gas (18) from a first gas supply nozzle (9A) to one plasma-generation space (8A) between the cathode (6) and one anode (5); and
supplying a polymeric gas (17) from another first gas supply nozzle (9B) to the other plasma-generation space (8B) between the cathode (6) and the other anode (5).

15. The plasma CVD method according to claim 11, wherein the plasma CVD electrode unit (4) comprises two facing anodes (5) and the cathode (6) provided at a distance from the anodes (5) in a space between the anodes (5), further comprising supplying a non-polymeric gas (18) from the first gas supply nozzle (9) to each plasma-generation space (8) between the cathode (6) and each anode (5).

16. The plasma CVD method according to any of claims 13 to 15, further comprising supplying a polymeric gas (17) from the second gas supply nozzle (15) to each space which is surrounded by each anode (5) and the substrate-holding mechanism (2) and is divided by a plane which includes the cathode (6) and is perpendicular to the substrate-holding mechanism (2), or
further comprising:
supplying a kind of polymeric gas (17A) from a second gas supply nozzle (15A) to one space which is surrounded by one anode (5) and the substrate-holding mechanism (2) and is divided by a plane which includes the cathode (6) and is perpendicular to the substrate-holding mechanism (2); and
supplying another kind of polymeric gas (17B) from another second gas supply nozzle (15B) to the other space which is surrounded by the other anode (5) and the substrate-holding mechanism (2) and is divided by a plane which includes the cathode (6) and is perpendicular to the substrate-holding mechanism (2), or
further comprising:
supplying a non-polymeric gas (18) from a second gas supply nozzle (15A) to one space which is surrounded by one anode (5) and the substrate-holding mechanism and is divided by a plane which includes the cathode (6) and is perpendicular to the substrate-holding mechanism (2); and
supplying a polymeric gas (17) from another second gas supply nozzle (15B) to the other space which is surrounded by the other anode (5) and the substrate-holding mechanism (2) and is divided by a plane which includes the cathode (6) and is perpendicular to the substrate-holding mechanism (2).

17. The plasma CVD method according to any one of claims 12 to 14 and 16, wherein the polymeric gas (17) of which molecule has Si atom and/or C atom.

## Patentansprüche

1. Vorrichtung für plasmaunterstütztes CVD, umfassend eine Elektrodeneinheit (4) für plasmaunterstütztes CVD und einen Substrat-Haltemechanismus (2) in einer Vakuumkammer (1), wobei die Elektrodeneinheit (4) für plasmaunterstütztes CVD umfasst:
eine Anode (5);
eine Kathode (6), welche mit einem Abstand zur Anode (5) gerichtet ist; und
eine erste Gaszufuhrdüse (9), welche zum Zuführen eines Gases durch einen Plasmaerzeugungsraum (8) zwischen der Anode (5) und der Kathode (6) angeordnet ist,
wobei der Substrat-Haltemechanismus (2) an einer Position vorgesehen ist, um während der Anwendung das den Plasmaerzeugungsraum (8) passierende Gas zu berühren,
wobei eine Gaszufuhrrichtungs-Länge der Anode (5) und eine Gaszufuhrrichtungs-Länge der Kathode (6) größer als ein Abstand zwischen der Anode (5) und der Kathode sind, **dadurch gekennzeichnet, dass**
die Elektrodeneinheit (4) für plasmaunterstütztes CVD ferner eine zweite Gaszufuhrdüse (15) umfasst, welche angeordnet ist, um ein weiteres Gas ohne den Plasmaerzeugungsraum (8) zu passieren zuzuführen, und
die zweite Gaszufuhrdüse (15) in einem Raum (19A, 19B) zwischen der Kathode (6) und dem Substrat-Haltemechanismus (2) vorgesehen ist.

2. Vorrichtung für plasmaunterstütztes CVD nach Anspruch 1, wobei die Kathode (6) eine Plasmaerzeugungsoberfläche (11) auf einer Seite, welche zur Anode (5) gerichtet ist, und im Inneren einen Magneten (12) aufweist, welcher ein Magnetron-Magnetfeld auf der Plasmaerzeugungsoberfläche (11) bildet.

3. Vorrichtung für plasmaunterstütztes CVD nach Anspruch 1, wobei die Kathode aus zwei oder mehr in der Gaszufuhrrichtung aufgereihten zylindrischen Metallelektroden gebildet ist und eine Mehrzahl von Magneten in der zylindrischen Metallelektrode eingeführt ist.

4. Vorrichtung für plasmaunterstütztes CVD nach einem der Ansprüche 1 bis 3, wobei die Elektrodeneinheit (4) für plasmaunterstütztes CVD zwei zueinander gerichtete Anoden (5) aufweist und die Kathode (6) mit einem Abstand von den Anoden (5) in einem Raum zwischen den Anoden (5) vorgesehen ist.

5. Vorrichtung für plasmaunterstütztes CVD nach einem der Ansprüche 1 bis 4, wobei die Gaszufuhrrichtungs-Länge der Kathode (6) 50 mm bis 300 mm ist.

6. Vorrichtung für plasmaunterstütztes CVD nach einem der Ansprüche 1 bis 5, wobei ein Abstand zwischen der Anode (5) und der Kathode (6) 13 mm bis 30 mm ist.

7. Vorrichtung für plasmaunterstütztes CVD nach einem der Ansprüche 1 bis 6, wobei ein kürzester Abstand zwischen der Anode (5) und dem Substrat-Haltemechanismus (2) und ein weiterer kürzester Abstand zwischen der Kathode (6) und dem Substrat-Haltemechanismus (2) 50 mm bis 200 mm sind.

8. Vorrichtung für plasmaunterstütztes CVD nach einem der Ansprüche 1 bis 7, wobei die Elektrodeneinheit (4) für plasmaunterstütztes CVD mit einer Bodenplatte (10) vorgesehen ist, welche aus der Sicht der Anode (5) und der Kathode (6) dem Substrat-Haltemechanismus (2) gegenüberliegt,
wobei die Bodenplatte (10) von der Kathode (6) elektrisch isoliert ist und mit der ersten Gaszufuhrdüse (9) versehen ist.

9. Vorrichtung für plasmaunterstütztes CVD nach einem der Ansprüche 1 bis 8, wobei die zweite Gaszufuhrdüse (15) mit einer Mehrzahl von Gaszufuhröffnungen (16) vorgesehen ist,
wobei mindestens eine der Gaszufuhröffnungen (16) eine Gaszufuhrrichtung aufweist, welche von einer Ebene, welche die zweite Gaszufuhrdüse (15) aufweist und senkrecht zum Substrat-Haltemechanismus (2) ist, aus zur Plasmaerzeugungsraumseite geneigt ist.

10. Vorrichtung für plasmaunterstütztes CVD nach einem der Ansprüche 1 bis 8, wobei die Elektrodeneinheit (4) für plasmaunterstütztes CVD zwei zueinander gerichtete Anoden (5) umfasst und die Kathode (6) mit einem Abstand von den Anoden (5) in einem Raum zwischen den Anoden (5) vorgesehen ist,
wobei die zweite Gaszufuhrdüse (15) in jedem Raum vorgesehen ist, welcher von den zwei Anoden (5) und dem Substrat-Haltemechanismus (2) umgeben und durch eine Ebene geteilt wird, welche die Kathode (6) aufweist und senkrecht zum Substrat-Haltemechanismus (2) ist.

11. Verfahren für plasmaunterstütztes CVD, welches mit der Vorrichtung für plasmaunterstütztes CVD nach einem der Ansprüche 1 bis 10 durchgeführt wird, aufweisend:
Halten eines Substrats (3) mit dem Substrat-Haltemechanismus (2);
Erzeugen eines Plasmas in dem Plasmaerzeugungsraum (8);
Zuführen eines Gases von der ersten Gaszufuhrdüse (9) durch den Plasmaerzeugungsraum (8) zum Substrat (3);
Zuführen eines weiteren Gases von der zweiten Gaszufuhrdüse (15), ohne dass es durch den Plasmaerzeugungsraum (8) passiert; und
Bilden eines Dünnfilms auf dem Substrat (3).

12. Verfahren für plasmaunterstütztes CVD nach Anspruch 11, ferner aufweisend:
Zuführen eines nicht polymerischen Gases (18) von der ersten Gaszufuhrdüse (9); und
Zuführen eines polymerischen Gases (17) von der zweiten Gaszufuhrdüse (15).

13. Verfahren für plasmaunterstütztes CVD nach Anspruch 11, wobei die Elektrodeneinheit (4) für plasmaunterstütztes CVD zwei zueinander gerichtete Anoden (5) umfasst und die Kathode (6) mit einem Abstand von den Anoden (5) in einem Raum zwischen den Anoden (5) vorgesehen ist, ferner aufweisend:
Zuführen einer Art polymerischen Gases (17A) von einer ersten Gaszufuhrdüse (9A) zu einem Plasmaerzeugungsraum (8A) zwischen der Kathode (6) und einer Anode (5); und
Zuführen einer weiteren Art polymerischen Gases (17B) von einer weiteren ersten Gaszufuhrdüse (9B) zum anderen Plasmaerzeugungsraum (8B) zwischen der Kathode (6) und der anderen Anode (5).

14. Verfahren für plasmaunterstütztes CVD nach Anspruch 11, wobei die Elektrodeneinheit (4) für plasmaunterstütztes CVD zwei zueinander gerichtete Anoden (5) umfasst und die Kathode (6) mit einem Abstand von den Anoden (5) in einem Raum zwischen den Anoden (5) vorgesehen ist; ferner aufweisend:
Zuführen eines nicht polymerischen Gases (18) von einer ersten Gaszufuhrdüse (9A) zu einem Plasmaerzeugungsraum (8A) zwischen der Kathode (6) und einer Anode (5); und
Zuführen eines polymerischen Gases (17) von einer weiteren ersten Gaszufuhrdüse (9B) zum anderen Plasmaerzeugungsraum (8B) zwischen der Kathode (6) und der anderen Anode (5).

15. Verfahren für plasmaunterstütztes CVD nach Anspruch 11, wobei die Elektrodeneinheit (4) für plasmaunterstütztes CVD zwei zueinander gerichtete Anoden (5) umfasst und die Kathode (6) mit einem Abstand von den Anoden (5) in einem Raum zwischen den Anoden (5) vorgesehen ist, ferner aufweisend Zuführen eines nicht polymerischen Gases (18) von der ersten Gaszufuhrdüse (9) zu jedem Plasmaerzeugungsraum (8) zwischen der Kathode (6) und jeder Anode (5).

16. Verfahren für plasmaunterstütztes CVD nach einem der Ansprüche 13 bis 15, ferner aufweisend Zuführen eines polymerischen Gases (17) von der zweiten Gaszufuhrdüse (15) zu jedem Raum, welcher von jeder Anode (5) und dem Substrat-Haltemechanismus (2) umgeben und durch eine Ebene geteilt wird, welche die Kathode (6) aufweist und senkrecht zum Substrat-Haltemechanismus (2) ist, oder
ferner aufweisend:
Zuführen einer Art polymerischen Gases (17A) von einer zweiten Gaszufuhrdüse (15A) zu einem Raum, welcher von einer Anode (5) und dem Substrat-Haltemechanismus (2) umgeben und durch eine Ebene geteilt wird, welche die Kathode (6) aufweist und senkrecht zum Substrat-Haltemechanismus (2) ist; und
Zuführen einer weiteren Art polymerischen Gases (17B) von einer weiteren zweiten Gaszufuhrdüse (15B) zum anderen Raum, welcher von der anderen Anode (5) und dem Substrat-Haltemechanismus (2) umgeben und durch eine Ebene geteilt wird, welche die Kathode (6) aufweist und senkrecht zum Substrat-Haltemechanismus (2) ist, oder
ferner aufweisend:
Zuführen eines nicht polymerischen Gases (18) von einer zweiten Gaszufuhrdüse (15A) zu einem Raum, welcher von einer Anode (5) und dem Substrat-Haltemechanismus umgeben und durch eine Ebene geteilt wird, welche die Anode (6) aufweist und senkrecht zum Substrat-Haltemechanismus (2) ist; und
Zuführen eines polymerischen Gases (17) von einer weiteren zweiten Gaszufuhrdüse (15B) zum anderen Raum, welcher von der anderen Anode (5) und dem Substrat-Haltemechanismus (2) umgeben und durch eine Ebene geteilt wird, welche die Kathode (6) aufweist und senkrecht zum Substrat-Haltemechanismus (2) ist.

17. Verfahren für plasmaunterstütztes CVD nach einem der Ansprüche 12 bis 14 und 16, wobei dessen polymerische Gas (17) Moleküle mit einem Si-Atom und/oder einem C-Atom aufweist.

## Revendications

1. Dispositif de dépôt chimique en phase vapeur (CVD) assisté par plasma comprenant une unité d'électrode de dépôt CVD assisté par plasma (4) et un mécanisme de maintien de substrat (2) dans une chambre à vide (1), où l'unité d'électrode de dépôt CVD assisté par plasma (4) comprend :
une anode (5) ;
une cathode (6) faisant face à l'anode (5) à une certaine distance ; et
une première buse d'alimentation en gaz (9) agencée pour fournir un gaz à travers un espace de génération de plasma (8) entre l'anode (5) et la cathode (6),
le mécanisme de maintien de substrat (2) étant prévu à une position pour entrer en contact, en cours d'utilisation, avec le gaz traversant l'espace de génération de plasma (8),
dans lequel une longueur directionnelle d'alimentation en gaz de l'anode (5) et une longueur directionnelle d'alimentation en gaz de la cathode (6) sont plus longues que la distance entre l'anode (5) et la cathode,
**caractérisé en ce que**
l'unité d'électrode de dépôt CVD assisté par plasma (4) comprend en outre une deuxième buse d'alimentation en gaz (15) agencée pour fournir un autre gaz sans traverser l'espace de génération de plasma (8), et
la deuxième buse d'alimentation en gaz (15) est prévue dans un espace (19A, 19B) entre la cathode (6) et le mécanisme de maintien de substrat (2).

2. Dispositif de dépôt CVD assisté par plasma selon la revendication 1, dans lequel la cathode (6) a une surface de génération de plasma (11) sur un côté faisant face à l'anode (5) et un aimant (12) à l'intérieur qui forme un champ magnétique de magnétron sur la surface de génération de plasma (11).

3. Dispositif de dépôt CVD assisté par plasma selon la revendication 1, dans lequel la cathode est constituée de deux électrodes cylindriques métalliques en réseau ou plus dans la direction d'alimentation en gaz et une pluralité d'aimants qui sont insérés à l'intérieur de l'électrode cylindrique métallique.

4. Dispositif de dépôt CVD assisté par plasma selon l'une quelconque des revendications 1 à 3, dans lequel l'unité d'électrode de dépôt CVD assisté par plasma (4) comprend deux anodes en regard (5) et la cathode (6) prévue à une certaine distance des anodes (5) dans un espace entre les anodes (5).

5. Dispositif de dépôt CVD assisté par plasma selon l'une quelconque des revendications 1 à 4, dans lequel la longueur directionnelle d'alimentation en gaz de la cathode (6) est comprise entre 50 mm et 300 mm.

6. Dispositif de dépôt CVD assisté par plasma selon l'une quelconque des revendications 1 à 5, dans lequel la distance entre l'anode (5) et la cathode (6) est comprise entre 13 mm et 30 mm.

7. Dispositif de dépôt CVD assisté par plasma selon l'une quelconque des revendications 1 à 6, dans lequel la distance la plus courte entre l'anode (5) et le mécanisme de maintien de substrat (2) et l'autre distance la plus courte entre la cathode (6) et le mécanisme de maintien de substrat (2) sont comprises entre 50 mm et 200 mm.

8. Dispositif de dépôt CVD assisté par plasma selon l'une quelconque des revendications 1 à 7, dans lequel l'unité d'électrode de dépôt CVD assisté par plasma (4) est munie d'une plaque inférieure (10) opposée au mécanisme de maintien de substrat (2) lorsque l'on regarde depuis l'anode (5) et la cathode (6),
la plaque inférieure (10) étant électriquement isolée de la cathode (6) et munie de la première buse d'alimentation en gaz (9).

9. Dispositif de dépôt CVD assisté par plasma selon l'une des revendications 1 à 8, dans lequel la deuxième buse d'alimentation en gaz (15) est munie d'une pluralité d'orifices d'alimentation en gaz (16),
au moins l'un des orifices d'alimentation en gaz (16) ayant une direction d'alimentation en gaz inclinée vers le côté de l'espace de génération de plasma à partir d'un plan qui comporte la deuxième buse d'alimentation en gaz (15) et est perpendiculaire au mécanisme de maintien de substrat (2).

10. Dispositif de dépôt CVD assisté par plasma selon l'une des revendications 1 à 8, dans lequel l'unité d'électrode de dépôt CVD assisté par plasma (4) comprend deux anodes en regard (5) et la cathode (6) prévue à une certaine distance des anodes (5) dans un espace entre les anodes (5),
la deuxième buse d'alimentation en gaz (15) étant prévue dans chaque espace qui est entouré par les deux anodes (5) et le mécanisme de maintien de substrat (2) et est divisé par un plan qui comporte la cathode (6) et est perpendiculaire au mécanisme de maintien de substrat (2).

11. Procédé de dépôt CVD assisté par plasma effectué avec le dispositif de dépôt CVD assisté par plasma selon l'une quelconque des revendications 1 à 10, comprenant le fait :
de maintenir un substrat (3) avec le mécanisme de maintien de substrat (2) ;
de générer un plasma dans l'espace de génération de plasma (8) ;
de fournir un gaz à partir de la première buse d'alimentation en gaz (9) à travers l'espace de génération de plasma (8) vers le substrat (3) ;
de fournir un autre gaz à partir de la deuxième buse d'alimentation en gaz (15) sans traverser l'espace de génération de plasma (8) ; et
de former un film mince sur le substrat (3).

12. Procédé de dépôt CVD assisté par plasma selon la revendication 11, comprenant en outre le fait :
de fournir un gaz non polymère (18) à partir de la première buse d'alimentation en gaz (9) ; et
de fournir un gaz polymère (17) à partir de la deuxième buse d'alimentation en gaz (15).

13. Procédé de dépôt CVD assisté par plasma selon la revendication 11, dans lequel l'unité d'électrode de dépôt CVD assisté par plasma (4) comprend deux anodes en regard (5) et la cathode (6) prévue à une certaine distance des anodes (5) dans un espace entre les anodes (5), comprenant en outre le fait :
de fournir un type de gaz polymère (17A) à partir d'une première buse d'alimentation en gaz (9A) à un espace de génération de plasma (8A) entre la cathode (6) et une anode (5) ; et
de fournir un autre type de gaz polymère (17B) à partir d'une autre première buse d'alimentation en gaz (9B) à l'autre espace de génération de plasma (8B) entre la cathode (6) et l'autre anode (5).

14. Procédé de dépôt CVD assisté par plasma selon la revendication 11, dans lequel l'unité d'électrode de dépôt CVD assisté par plasma (4) comprend deux anodes en regard (5) et la cathode (6) prévue à une certaine distance des anodes (5) dans un espace entre les anodes (5), comprenant en outre le fait :
de fournir un gaz non polymère (18) à partir d'une première buse d'alimentation en gaz (9A) à un espace de génération de plasma (8A) entre la cathode (6) et une anode (5) ; et
de fournir un gaz polymère (17) à partir d'une autre première buse d'alimentation en gaz (9B) à l'autre espace de génération de plasma (8B) entre la cathode (6) et l'autre anode (5).

15. Procédé de dépôt CVD assisté par plasma selon la revendication 11, dans lequel l'unité d'électrode de dépôt CVD assisté par plasma (4) comprend deux anodes en regard (5) et la cathode (6) prévue à une certaine distance des anodes (5) dans un espace entre les anodes (5), comprenant en outre le fait de fournir un gaz non polymère (18) à partir de la première buse d'alimentation en gaz (9) à chaque espace de génération de plasma (8) entre la cathode (6) et chaque anode (5).

16. Procédé de dépôt CVD assisté par plasma selon l'une des revendications 13 à 15, comprenant en outre le fait de fournir un gaz polymère (17) à partir de la deuxième buse d'alimentation en gaz (15) à chaque espace qui est entouré par chaque anode (5) et le mécanisme de maintien de substrat (2) et est divisé par un plan qui comporte la cathode (6) et est perpendiculaire au mécanisme de maintien de substrat (2), ou
comprenant en outre le fait :
de fournir un type de gaz polymère (17A) à partir d'une deuxième buse d'alimentation en gaz (15A) à un espace qui est entouré par une anode (5) et le mécanisme de maintien de substrat (2) et est divisé par un plan qui comporte la cathode (6) et est perpendiculaire au mécanisme de maintien de substrat (2) ; et
de fournir un autre type de gaz polymère (17B) à partir d'une autre deuxième buse d'alimentation en gaz (15B) à l'autre espace qui est entouré par l'autre anode (5) et le mécanisme de maintien de substrat (2) et est divisé par un plan qui comporte la cathode (6) et est perpendiculaire au mécanisme de maintien de substrat (2), ou
comprenant en outre le fait :
de fournir un gaz non polymère (18) à partir d'une deuxième buse d'alimentation en gaz (15A) à un espace qui est entouré par une anode (5) et le mécanisme de maintien de substrat et est divisé par un plan qui comporte la cathode (6) et est perpendiculaire au mécanisme de maintien de substrat (2) ; et
de fournir un gaz polymère (17) à partir d'une autre deuxième buse d'alimentation en gaz (15B) à l'autre espace qui est entouré par l'autre anode (5) et le mécanisme de maintien de substrat (2) et est divisé par un plan qui comporte la cathode (6) et est perpendiculaire au mécanisme de maintien de substrat (2).

17. Procédé de dépôt CVD assisté par plasma selon l'une quelconque des revendications 12 à 14 et 16, dans lequel la molécule du gaz polymère (17) a un atome de Si et/ou un atome de C.
